# EUROPEAN PATENT APPLICATION

(11) **EP 4 492 429 A1**
(43) Date of publication of application: **15.01.2025**
(21) Application number: 23766624.3
(22) Date of filing: 27.02.2023
(51) Int. Cl.: H01L 21/02

(54) **SUBSTRATE PROCESSING DEVICE MANAGEMENT SYSTEM, MANAGEMENT DEVICE, SUBSTRATE PROCESSING DEVICE, SUBSTRATE PROCESSING DEVICE MANAGEMENT METHOD, AND SUBSTRATE PROCESSING DEVICE MANAGEMENT PROGRAM**

(30) Priority: 11.03.2022 JP 2022038502
(71) Applicant: SCREEN Holdings Co., Ltd., Kyoto-shi, Kyoto 602-8585 (JP)
(72) Inventor: YOSHIHARA, Koki, Kyoto-shi, Kyoto 602-8585 (JP); MATSUI, Hiroakira, Kyoto-shi, Kyoto 602-8585 (JP); SEIWA, Takaaki, Kyoto-shi, Kyoto 602-8585 (JP)
(74) Representative: Kilian Kilian & Partner mbB
(86) International application number: PCT/JP2023/007075
(87) International publication number: WO 2023/171446

(57) **Abstract**

A substrate processing apparatus includes a gas-exhaust path to which a predetermined exhaust force is applied, and a plurality of substrate processing units configured to share the gas-exhaust path. Group correlations are predetermined as correlations in regard to a plurality of processing information pieces which correspond to each of the plurality of substrate processing units and represent work or a state relating to supply and exhaust of gas, and a management device that manages the substrate processing apparatus acquires a plurality of processing information pieces corresponding to each of the plurality of substrate processing units, and detects a state prior to a state in which the plurality of substrate processing apparatuses become abnormal, based on comparison information obtained when correlations in regard to a plurality of processing information pieces relating to exhaust of gas among a plurality of processing information pieces are compared with the group correlations.

## Description

### [Technical Field]

The present invention relates to a substrate processing apparatus management system, a management device, a substrate processing apparatus, a substrate processing apparatus management method and a substrate processing apparatus management program, and relates to a substrate processing apparatus management system that manages a substrate processing apparatus in which a plurality of substrate processing units share a gas-exhaust path, a management device included in the substrate processing apparatus management system, the substrate processing apparatus including the management device, a substrate processing apparatus management method executed in the management device, and a substrate processing apparatus management program that causes a computer to execute the substrate processing apparatus management method.

### [Background Art]

A substrate processing apparatus that processes a substrate such as a semiconductor substrate (semiconductor wafer) includes a plurality of chambers in which a substrate process is executed and a gas supply-exhaust system for maintaining cleanliness of an atmosphere in each of chambers. JP 2021-136435 A describes a substrate processing apparatus that exhausts air in a plurality of chambers through one exhaust pipe. In this substrate processing apparatus, the gas-exhaust pressure in the chamber is adjusted by an opening (degree of opening) of a damper.

Generally, the inside of the chamber of the substrate processing apparatus is maintained to have a constant pressure in order to prevent particles from splashing. In each of the plurality of chambers, in order to keep an appropriate pressure in the chamber, the gas-supply pressure and the gas-exhaust pressure are respectively controlled to be target pressures.
[Patent Document 1] JP 2021-136435 A

### [Summary of Invention]

### [Technical Problem]

Even in a state in which the internal pressure of the chamber is maintained at a constant pressure for connection of the plurality of chambers to one gas-exhaust pipe, the opening of a damper of one or more chambers may indicate an upper limit value. Further, in a special case such as a case in which a force applied to the gas-exhaust pipe is reduced, when the opening of the damper is increased in the chamber in which the opening of the damper is equal to or smaller than the upper limit value after reduction of the force, a gas-exhaust pressure may decrease in one or more chambers in which the opening of the damper indicates the upper limit value. In a case in which a gas-exhaust pressure in the chamber decreases, an abnormality in which the pressure in the chamber decreases is detected, and the substrate processing apparatus is stopped.

An object of the present invention is to provide a substrate processing apparatus management system, a management device, a substrate processing apparatus, a substrate processing apparatus management method and a substrate processing apparatus management program, which prevent a decrease in work rate of the substrate processing apparatus.

### [Solution to Problem]

According to one aspect of the present invention, a substrate processing apparatus management system includes a management device that manages a substrate processing apparatus, and an information analysis device, wherein the substrate processing apparatus includes a gas-exhaust path to which a predetermined use force is applied, and a plurality of substrate processing units configured to share the gas-exhaust path, the information analysis device includes a model generator that generates group correlations as correlations in regard to a plurality of processing information pieces which correspond to each of the plurality of substrate processing units and represent work or a state relating to supply and exhaust of gas, and the management device includes a processing information acquirer that acquires a plurality of processing information pieces corresponding to each of the plurality of substrate processing units, and a detector that detects a state prior to a state in which the plurality of substrate processing apparatuses become abnormal, based on comparison information obtained when correlations in regard to a plurality of processing information pieces relating to exhaust of gas among a plurality of processing information pieces acquired by the processing information acquirer are compared with the group correlations.

According to this aspect, in a case in which the group correlations represent the correlations in regard to processing information pieces obtained in a case in which the substrate processing units work normally, the work or state relating to exhaust of gas in each of the plurality of substrate processing units sharing the gas-exhaust path can be compared with the work or state in each of the plurality of substrate processing units working normally. Therefore, it is possible to detect that the work or state relating to exhaust of gas in each of the plurality of substrate processing units sharing the gas-exhaust path is different from the work or state relating to exhaust of gas in each of the substrate processing units working normally. Therefore, it is possible to detect the state prior to the state in which any of the plurality of substrate processing units sharing the gas-exhaust path becomes abnormal. As a result, it is possible to provide the substrate processing apparatus management system which predicts an occurrence of an abnormality in the plurality of substrate processing units and prevents the work rate of the substrate processing apparatus from decreasing.

According to another aspect of the present invention, a management device manages a substrate processing apparatus, wherein the substrate processing apparatus includes a gas-exhaust path to which a predetermined use force is applied, and a plurality of substrate processing units configured to share the gas-exhaust path, group correlations are predetermined as correlations in regard to a plurality of processing information pieces which correspond to each of the plurality of substrate processing units and represent work or a state relating to supply and exhaust of gas, and the management device includes a processing information acquirer that acquires a plurality of processing information pieces corresponding to each of the plurality of substrate processing units, and a detector that detects a state prior to a state in which the plurality of substrate processing apparatuses become abnormal, based on comparison information obtained when correlations in regard to a plurality of processing information pieces relating to exhaust of gas among a plurality of processing information pieces acquired by the processing information acquirer are compared with the group correlations.

According to this aspect, in a case in which the group correlations represent the correlations in regard to processing information pieces obtained in a case in which the substrate processing units work normally, the work or state relating to exhaust of gas in each of the plurality of substrate processing units sharing the gas-exhaust path can be compared with the work or state in each of the plurality of substrate processing units working normally. Therefore, it is possible to detect that the work or state relating to exhaust of gas in each of the plurality of substrate processing units sharing the gas-exhaust path is different from the work or state relating to exhaust of gas in each of the substrate processing units working normally.

Preferably, types of a plurality of processing information pieces respectively acquired from the plurality of substrate processing units are same.

According to this aspect, because the same types of the processing information pieces are acquired from the plurality of substrate processing units belonging to the group, the correlations are compared with the correlations obtained when the substrate processing units are working normally, with the correlations regarding the same types of the processing information pieces. Therefore, comparison can be made in regard to the correlations for the same types of the processing information pieces for the plurality of substrate processing units.

Preferably, the management device further includes a deviation-degree acquirer that, for each of the plurality of substrate processing units, acquires deviation-degree information pieces representing respective degrees of deviations between respective predicted values and respective processing information pieces that corresponds to the substrate processing unit and is acquired by the processing information acquirer, with the predicted values being predicted using the group correlations based on processing information pieces that correspond to the substrate processing unit and is acquired by the processing information acquirer.

According to this aspect, because the predicted values for the processing information pieces corresponding to the substrate processing unit are predicted using the group correlations based on the processing information pieces, it is possible to compare the correlations with the correlations obtained when the substrate processing unit is working normally, with the correlations relating to the work or state for exhaust of gas in the substrate processing unit. Because the deviation-degree information pieces representing degrees of deviation between the predicted values and the processing information pieces are acquired, it is possible to represent the differences of the correlations from the correlations obtained when the substrate processing unit is working normally, with the correlations relating to the work or state for exhaust of gas.

Preferably, each of the plurality of substrate processing units includes a gas supplier that supplies gas into the substrate processing unit, a first manometer that measures a pressure of gas supplied into the substrate processing unit, a first controller that controls the gas supplier such that a pressure measured by the first manometer is a first target value, a gas exhauster that adjusts a size of an opening that connects an inner space of the substrate processing unit to the gas-exhaust path, a second manometer that measures a pressure of gas exhausted from the substrate processing unit, and the second controller that controls the gas exhauster such that a pressure measured by the second manometer is a second target value, the processing information pieces include a first pressure value measured by the first manometer, a work amount of the gas supplier, an operation amount output by the first controller to the gas supplier, a second pressure value measured by the second manometer and an opening indicating a size of the opening output by the second controller to the gas exhauster, and a processing information piece relating to the exhaust of gas is the opening.

According to this aspect, the correlations in regard to the first pressure value, the work amount of the gas supplier, the operation amount of the gas supplier, the second pressure value and the size of the opening of the gas exhauster are determined as the group correlations, and the correlations are compared with the correlations obtained when the substrate processing unit is working normally, with the correlations relating to the opening for the plurality of substrate processing apparatuses. Therefore, the gas-exhaust states of the plurality of substrate processing units can be compared with the gas-exhaust states of the plurality of substrate processing units working normally.

Preferably, each of the plurality of substrate processing units processes a substrate according to any one of a plurality of types of recipes, and the processing information pieces further include information pieces specifying the processing recipe according to which a substrate is processed in the substrate processing unit.

According to this aspect, in regard to each of the processing recipes, the correlations can be compared with the correlations obtained when a substrate processing unit is working normally.

Preferably, the gas-exhaust path has a plurality of different division paths, the gas exhauster includes a switcher that switches a path to one of the plurality of division paths, and the processing information pieces further include information pieces specifying the division path to which the path is switched by the switcher.

According to this aspect, in regard to each of the plurality of division paths, the correlations in regard to the plurality of substrate processing apparatuses can be compared with the correlations in regard to the plurality of substrate processing apparatus working normally.

Preferably, the substrate processing apparatus has a plurality of the gas-exhaust paths, the plurality of substrate processing units are classified into one of a plurality of groups respectively corresponding to the plurality of the gas-exhaust paths, in each of the plurality of groups, a plurality of substrate processing units classified into the group are configured to share a gas-exhaust path corresponding to the group among the plurality of gas-exhaust paths, for each of the plurality of groups, the group correlations are predetermined as correlations in regard to a plurality of processing information pieces which correspond to each of a plurality of substrate processing units classified into the group and represent work or a state relating to supply and exhaust of gas, and the detector, for each of a plurality of groups, detects a state prior to a state in which a plurality of substrate processing units classified into the group become abnormal based on comparison information obtained when correlations, in regard to a plurality of processing information pieces which correspond to each of a plurality of substrate processing units classified into the group and relate to exhaust of gas among a plurality of processing information pieces acquired by the processing information acquirer, are compared with the group correlations corresponding to the group.

According to this aspect, in regard to each of the plurality of gas-exhaust paths, it is possible to detect that the work or state is different from the work or state in a substrate processing unit working normally, with the work or state relating to exhaust of gas in the substrate processing units sharing the gas-exhaust path.

According to another aspect of the present invention, a substrate processing apparatus includes the above-mentioned management device.

According to yet another aspect of the present invention, a substrate processing apparatus management method is a substrate processing method of managing a substrate processing apparatus, wherein the substrate processing apparatus includes a gas-exhaust path to which a predetermined use force is applied, and a plurality of substrate processing units configured to share the gas-exhaust path, group correlations are predetermined as correlations in regard to a plurality of processing information pieces which correspond to each of the plurality of substrate processing units and represent work or a state relating to supply and exhaust of gas, and a substrate processing apparatus management method causes a management device to execute a process of acquiring a plurality of processing information pieces corresponding to each of the plurality of substrate processing units, and a process of detecting a state prior to a state in which the plurality of substrate processing apparatus become abnormal based on comparison information obtained when correlations in regard to a plurality of processing information pieces corresponding to each of the plurality of substrate processing units and relating to exhaust of gas among a plurality of processing information pieces acquired by the processing information acquirer are compared with the group correlations.

According to yet another aspect of the present invention, a substrate processing apparatus management program is a substrate processing apparatus management program for managing a substrate processing apparatus, wherein the substrate processing apparatus includes a gas-exhaust path to which a predetermined use force is applied, and a plurality of substrate processing units configured to share the gas-exhaust path, group correlations are predetermined as correlations in regard to a plurality of processing information pieces which correspond to each of the plurality of substrate processing units and represent work or a state relating to supply and exhaust of gas, and a substrate processing apparatus management method causes a management device to execute a process of acquiring a plurality of processing information pieces corresponding to each of the plurality of substrate processing units, and a process of detecting a state prior to a state in which the plurality of substrate processing apparatus become abnormal based on comparison information obtained when correlations in regard to a plurality of processing information pieces corresponding to each of the plurality of substrate processing units and relating to exhaust of gas among a plurality of processing information pieces acquired by the processing information acquirer are compared with the group correlations.

### [Advantageous Effects of Invention]

With the present invention, it is possible to prevent a reduction in work rate of the substrate processing apparatus.

### [Brief Description of the Drawings]

[FIG. 1] Fig. 1 is a diagram for explaining the configuration of a substrate processing apparatus management system according to one embodiment of the present invention.
[FIG. 2] Fig. 2 is a plan view showing the inside of a substrate processing apparatus of the present embodiment.
[FIG. 3] Fig. 3 is a cross-sectional view of a processing block of Fig. 2 taken along the line A-A.
[FIG. 4] Fig. 4 is a cross-sectional view of the processing block taken along the line B-B.
[FIG. 5] Fig. 5 is a plan view of a substrate processing unit.
[FIG. 6] Fig. 6 is a system diagram of a first gas-exhaust path and a second gas-exhaust path.
[FIG. 7] Fig. 7 is a system diagram of a third gas-exhaust path and a fourth gas-exhaust path.
[FIG. 8] Fig. 8 is a conceptual diagram for explaining the work of the substrate processing apparatus management system.
[FIG. 9] Fig. 9 is a diagram for explaining the specific example of calculation of deviation degrees.
[FIG. 10] Fig. 10 is a diagram showing one example of a deviation-degree table.
[FIG. 11] Fig. 11 is a diagram showing one example of a deviation-degree table for "e. OPENING."
[FIG. 12] Fig. 12 is a block diagram for explaining one example of the functional configurations of the substrate processing apparatus management system.
[FIG. 13] Fig. 13 is a flowchart showing one example of a flow of a processing information transmission process.
[FIG. 14] Fig. 14 is a flowchart showing one example of a flow of a model generation process.
[FIG. 15] Fig. 15 is a flowchart showing one example of a flow of a substrate processing apparatus management process.

### [Description of Embodiments]

A substrate processing apparatus management system according to one embodiment of the present invention will be described below with reference to the drawings. In the following description, a substrate refers to a semiconductor substrate (semiconductor wafer), a substrate for an FPD (Flat Panel Display) such as a liquid crystal display device or an organic EL (Electro Luminescence) display device, a substrate for an optical disc, a substrate for a magnetic disc, a substrate for a magneto-optical disc, a substrate for a photomask, a ceramic substrate, a substrate for a solar battery, or the like.

### 1. Overall Configuration of Substrate Processing Apparatus Management System

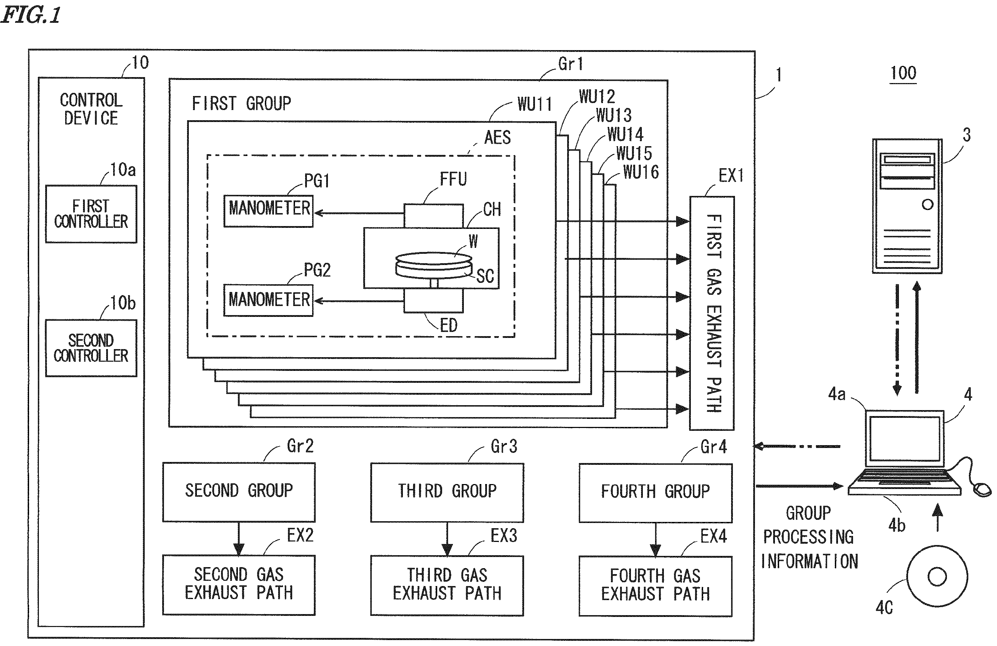

Fig. 1 is a diagram for explaining the configuration of the substrate processing apparatus management system according to the one embodiment of the present invention. The substrate processing apparatus management system 100 of Fig. 1 includes a substrate processing apparatus 1, an information analysis device 3 and a management device 4. The information analysis device 3 is a server, for example, and includes a CPU (Central Processing Unit) and a memory. The management device 4 is a personal computer, for example, and includes a CPU and a memory. Further, a CD-ROM (Compact Disc Read Only Memory) 4c, which is a computer-readable recording media, is attachable to and detachable from the management device 4, and the management device 4 can read and execute a program recorded in the CD-ROM 4c.

The information analysis device 3 and the management device 4 are used to manage the substrate processing apparatus 1. The number of substrate processing apparatuses 1 managed by the information analysis device 3 and the management device 4 is not limited to one, and a plurality of substrate processing apparatuses 1 may be managed.

The management device 4 according to the present embodiment is connected to each of the substrate processing apparatus 1 and the information analysis device 3 by a wired communication line or a wireless communication network. For example, the management device 4 is connected to each of the substrate processing apparatus 1 and the information analysis device 3 by a communication network such as the Internet or a Local Area Network. In the present embodiment, the management device 4 is connected to each of the substrate processing apparatus 1 and the information analysis device 3, wired or wireless.

In the substrate processing apparatus 1, a display device, a speech output device and an operation unit (not shown) are provided. The substrate processing apparatus 1 runs in accordance with a predetermined processing procedure (processing recipe) of the substrate processing apparatus 1.

### 2. Outline of Substrate Processing Apparatus

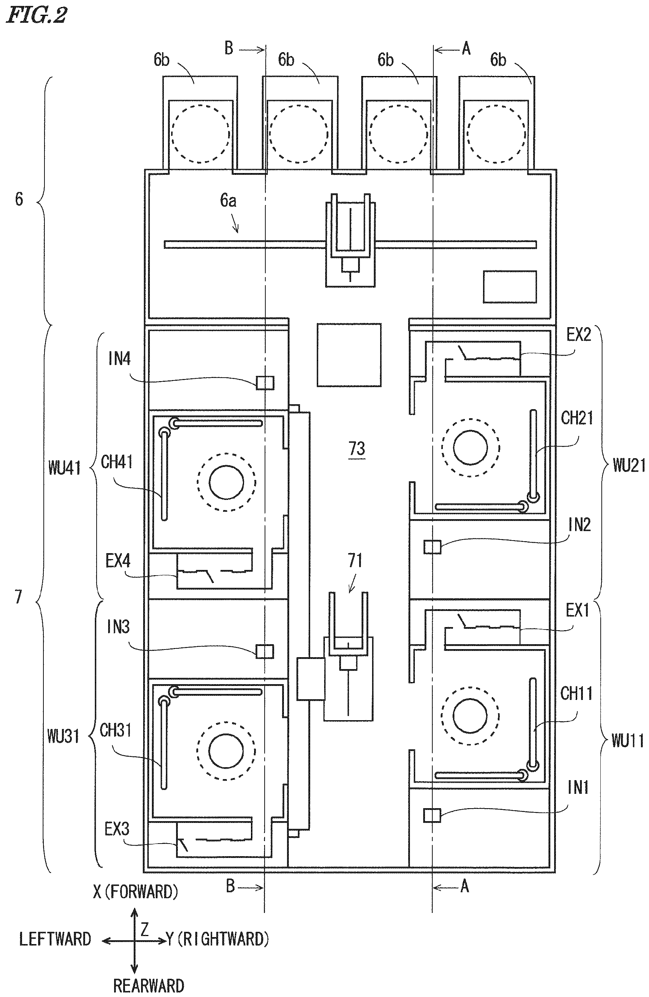

Fig. 2 is a plan view showing the inside of the substrate processing apparatus of the present embodiment. The substrate processing apparatus 1 includes an indexer section 6 and a processing block 7. The processing block 7 is connected to the indexer section 6. The indexer section 6 and the processing block 7 are arranged in a horizontal direction. The indexer section 6 includes a transport mechanism 6a. The transport mechanism 6a transports the substrate W placed on a carrier platform 6b to the processing block 7.

The horizontal direction in which the indexer section 6 and the processing block 7 are arranged is referred to as a "forward-and-rearward direction X." In the forward-and-rearward direction X, the direction directed from the processing block 7 toward the indexer section 6 is referred to as a "forward direction." The direction opposite to the forward direction is referred to as a "rearward direction." The horizontal direction orthogonal to the forward-and-rearward direction X is referred to as a "width direction Y." One direction of the "width direction Y" is suitably referred to as a "rightward direction." The direction opposite to the rightward direction is referred to as a "leftward direction." The direction orthogonal to the horizontal direction is referred to as a "vertical direction Z." In each diagram, forward, rearward, rightward, leftward, upward and downward are suitably indicated for reference.

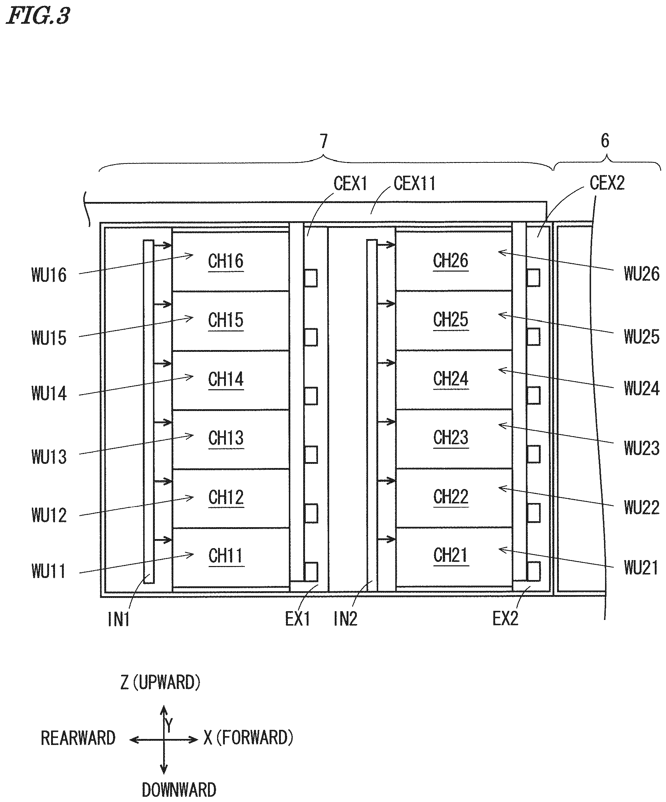

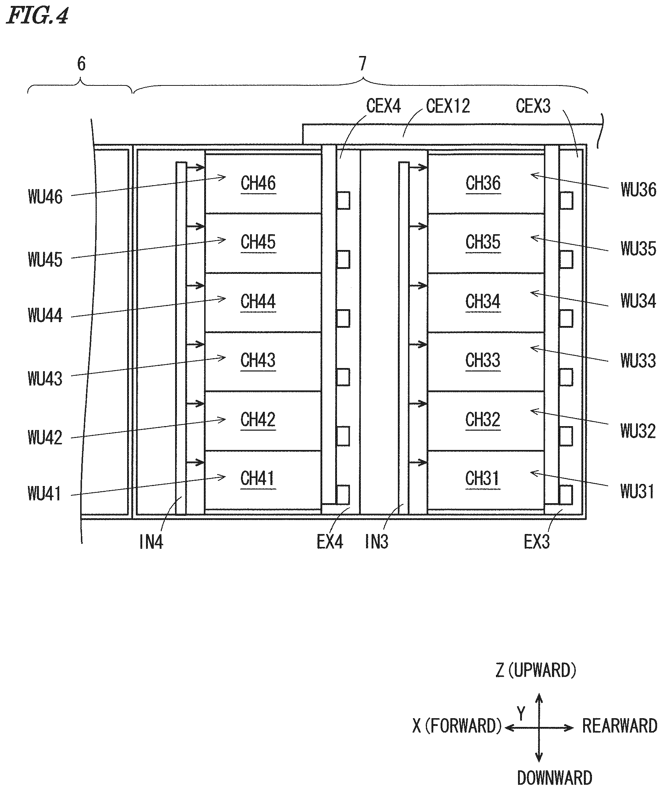

Fig. 3 is a cross-sectional view of the processing block of Fig. 2 taken along the line A-A. Fig. 4 is a cross-sectional view of the processing block taken along the line B-B. With reference to Figs. 2 to 4, the processing block 7 includes 24 substrate processing units WU11 to WU16, WU21 to WU26, WU31 to WU36, WU41 to WU46. The substrate processing units WU11 to WU16, WU21 to WU26, WU31 to WU36, WU41 to WU46 include chambers CH11 to CH16, CH21 to CH26, CH31 to CH36, CH41 to CH46, respectively. Hereinafter, the substrate processing units WU11 to WU16, WU21 to WU26, WU31 to WU36, WU41 to WU46 are collectively referred to as substrate processing units WU, and the chambers CH11 to CH16, CH21 to CH26, CH31 to CH36, CH41 to CH46 are collectively referred to as chambers CH.

The processing block 7 has a hierarchical structure in which six layers each of which includes four substrate processing units WU are stacked in the upward-and-downward direction. The substrate processing units WU11, WU21, WU31, WU41 are arranged in a first layer at the lowest level, the substrate processing units WU12, WU22, WU32, WU42 are arranged in a second layer above the first layer, the substrate processing units WU13, WU23, WU22, WU43 are arranged in a third layer above the second layer, the substrate processing units WU14, WU24, WU34, WU44 are arranged in a fourth layer above the third layer, the substrate processing units WU15, WU25, WU35, WU45 are arranged in a fifth layer above the fourth layer, and the substrate processing units WU16, WU26, WU36, WU46 are arranged in a sixth layer above the fifth layer.

The 6 substrate processing units WU arranged at positions overlapping with one another in plan view in the first to the sixth layers form a group. Specifically, the substrate processing units WU11 to WU16 form a first group Gr1, the substrate processing units WU21 to WU26 form a second group Gr2, the substrate processing units WU31 to WU36 form a third group, and the substrate processing units WU41 to WU46 form a fourth group Gr4.

The substrate processing units WU11 to WU16 belonging to the first group Gr1 are configured to be able to share a first gas-supply path IN1 and a first gas-exhaust path EX1. In other words, the chambers C11 to CH16 respectively included in the substrate processing units WU11 to WU16 are configured to be communicable with the first gas-supply path IN1 and are configured to be communicable with the first gas-exhaust path EX1. Similarly, the substrate processing units WU21 to WU26 belonging to the second group Gr2 are configured to be able to share a second gas-supply path IN2 and a second gas-exhaust path EX2, the substrate processing units WU31 to WU36 belonging to the third group Gr3 are configured to be able to share a third gas-supply path IN3 and a third gas-exhaust path EX3, and the substrate processing units WU41 to WU46 belonging to the fourth group Gr4 are configured to be able to share a fourth gas-supply path IN4 and a fourth gas-exhaust path EX4.

Fig. 2 shows the cross section of the first layer at the lowest level of the processing block 7. As shown in Fig. 2, substrate processing units WU11, WU21, WU31, WU41 are arranged in the first layer of the processing block 7. The processing block 7 includes a transport space 73. The substrate processing units WU11, WU21 are arranged in a rightward portion in the transport space 73, and the substrate processing unit WU11 is arranged rearwardly of the substrate processing unit WU21. The substrate processing units WU31, WU41 are arranged in a leftward portion in the transport space 73, and the substrate processing unit WU31 is arranged rearwardly of the substrate processing unit WU41.

The processing block 7 includes a transport mechanism 71 in the transport space 73. The transport mechanism 71 transports the substrate W received from the indexer section 6 to the chambers CH11, CH21, CH31, CH41 respectively included in the substrate processing units WU11, WU21, WU31, WU41.

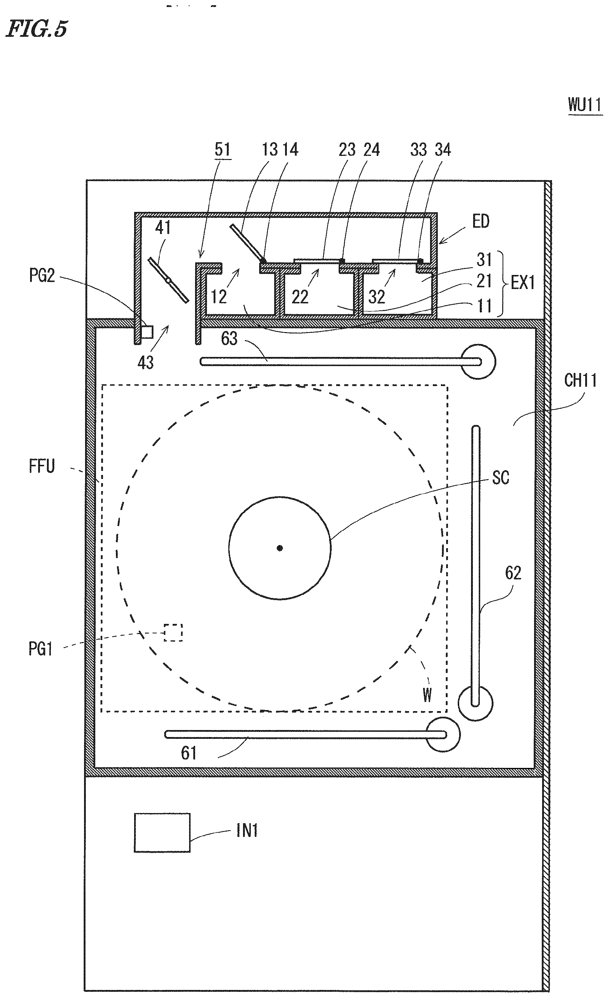

Fig. 5 is a plan view of the substrate processing unit. The substrate processing units WU11 to WU16, WU21 to WU26, WU31 to WU36, WU41 to WU46 all have the same configuration. Here, the substrate processing unit WU11 will be described as an example.

The substrate processing unit WU11 includes a chamber CH11, a spin chuck SC for holding and rotating the substrate W, a gas exhauster ED, a gas supplier FFU and nozzles 61, 62, 63. The chamber CH11 is a space partitioned for a substrate process, has an opening through which the substrate W can pass, and has a shutter (not shown) for opening and closing the opening.

The spin chucks SC and the three nozzles 61, 62, 63 are provided in the chamber CH11. The nozzle 61 discharges an acidic cleaning liquid, the nozzle 62 discharges an alkaline cleaning liquid, and the nozzle 63 discharges an organic solvent cleaning liquid. In the chamber CH11, the substrate W held by the spin chuck SC is cleaned when a cleaning liquid is supplied from any of the three nozzles 61, 62, 63.

In the top plate of the chamber CH11, the gas supplier FFU is arranged in the chamber CH11. The gas supplier FFU is connected to the first gas-supply path IN1 in order to supply a clean gas (air or an inert gas, for example) into the chamber CH11. The gas supplier FFU is a fan filter unit including a fan motor, for example. In the gas supplier FFU, a rotation speed of the fan motor is adjusted. Thus, a flow rate of gas supplied into the chamber CH is adjusted. A first pressure sensor PG1 is arranged in the gas supplier FFU. The first pressure sensor PG1 measures a value for the pressure of gas supplied to the chamber CH11 (hereinafter referred to as a first control pressure).

The gas exhauster ED connects the space inside of the chamber CH11 to the first gas-exhaust path EX1. In the chamber CH11, an opening 43 that opens the inner space of the chamber CH11 to the gas exhauster ED is formed. The space inside of the chamber CH11 communicates with the gas exhauster ED through the opening 43.

The gas exhauster ED includes an gas-exhaust damper 41 and a switching device 51. The opening (degree of opening) of the gas-exhaust damper 41 is adjusted by a damper motor, and the opening area of the opening 43 is changed. The opening of the gas-exhaust damper 41 is adjusted by the damper motor, so that the flow rate of gas exhausted from the chamber CH11 is adjusted. A second pressure sensor PG2 is arranged between the gas-exhaust damper 41 and the space inside of the chamber CH11. The second pressure sensor PG2 measures a value for the pressure of gas exhausted from the chamber CH11 (hereinafter referred to as a second control pressure).

The first gas-exhaust path EX1 includes a first division path 11 corresponding to an acidic chemical liquid, a second division path 21 corresponding to an alkaline chemical liquid, and a third division path 31 corresponding to an organic solvent chemical liquid. A first communication port 12 as an opening communicating with the chamber CH11 is formed in the first division path 11, a second communication port 22 as an opening communicating with the chamber CH11 is formed in the second division path 21, and a third communication port 32 as an opening communicating with the chamber CH11 is formed in the third division path 31.

The switching device 51 includes a first door 13, a second door 23 and a third door 33. The first door 13 has a rotation shaft 14 supported at the main body of the switching device 51 at its one end, and opens and closes the first communication port 12 by rotating about the rotation shaft 14. The second door 23 has a rotation shaft 24 supported at the main body of the switching device 51 at its one end, and opens and closes the second communication port 22 by rotating about the rotation shaft 24. The third door 33 has a rotation shaft 34 supported at the main body of the switching device 51 at its one end, and opens and closes the third communication port 32 by rotating about the rotation shaft 34. When one of the first door 13, the second door 23 and the third door 33 is opened and the other two doors are closed, gas in the chamber CH11 is guided to one of the first division path 11, the second division path 21 and the third division path 31.

Specifically, in a period during which the substrate is processed while the nozzle 61 discharges a chemical liquid in the chamber CH11, the first door 13 is opened, and the second door 23 and the third door 33 are closed. In a period during which the substrate is processed while the nozzle 62 discharges a chemical liquid in the chamber CH11, the second door 23 is opened, and the first door 13 and the third door 33 are closed. In a period during which the substrate is processed while the nozzle 63 discharges a chemical liquid in the chamber CH11, the third door 33 is opened, and the first door 13 and the second door 23 are closed.

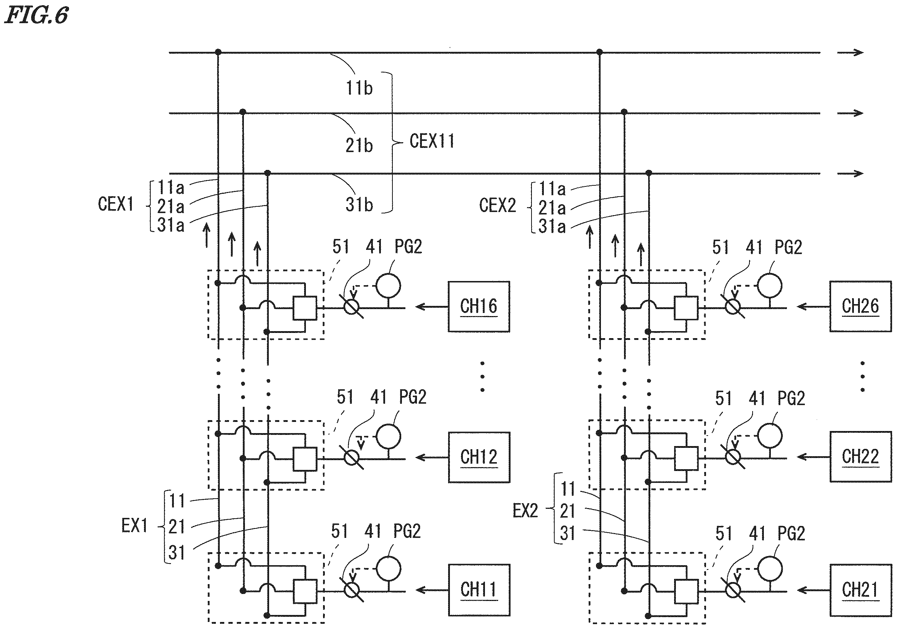

Fig. 6 is a system diagram of the first gas-exhaust path and the second gas-exhaust path. With reference to Fig. 6, each of the chambers CH11 to CH16 belonging to the first group Gr1 communicates with the first gas-exhaust path EX1. The gas-exhaust damper 41 and the second pressure sensor PG2 are provided between each of the chambers CH11 to CH16 and the first gas-exhaust path EX1. The switching device 51 is provided between the gas-exhaust damper 41 and the first gas-exhaust path EX1. Each of the chambers CH11 to CH16 communicates with one of the first division path 11, the second division path 21 and the third division path 31 included in the first gas-exhaust path EX1.

Each of the chambers CH21 to CH26 belonging to the second group Gr2 communicates with the second gas-exhaust path EX2. The gas-exhaust damper 41 and the second pressure sensor PG2 are provided between each of the chambers CH21 to CH16 and the second gas-exhaust path EX2. The switching device 51 is provided between the gas-exhaust damper 41 and the second gas-exhaust path EX2. Each of the chambers CH21 to CH26 communicates with one of the first division path 11, the second division path 21 and the third division path 31 of the second gas-exhaust path EX2.

The first gas-exhaust path EX1 is connected to a first common path CEX11. The first division path 11 of the first gas-exhaust path EX1 is connected to a first division common path 11b of the first common path CEX11, the second division path 21 of the first gas-exhaust path EX1 is connected to a second division common path 21b of the first common path CEX11, and the third division path 31 of the first gas-exhaust path EX1 is connected to a third division common path 31b of the first common path CEX11.

The second gas-exhaust path EX2 is connected to the first common path CEX11. The first division path 11 of the second gas-exhaust path EX2 is connected to the first division common path 11b of the first common path CEX11, the second division path 21 of the second gas-exhaust path EX2 is connected to the second division common path 21b of the first common path CEX11, and the third division path 31 of the second gas-exhaust path EX2 is connected to the third division common path 31b of the first common path CEX11.

An exhaust force is applied to the first common path CEX11 from an exhaust-force generation device in a factory. In the first gas-exhaust path EX1, the chambers CH11 to CH16 belonging to the first group Gr1 can share the path CEX1 extending from the portions communicating with the chamber CH16 being arranged at the highest level and belonging to the first group Gr1 to the portions connected to the first common path CEX11.

In the first division path 11 of the first gas-exhaust path EX1, the chambers CH11 to CH16 can share the path extending from the portion communicating with the chamber CH16 to the portion connected to the first division common path 11b of the first common path CEX11. In the second division path 21 of the first gas-exhaust path EX1, the chambers CH11 to CH16 can share the path extending from the portion communicating with the chamber CH16 to the portion connected to the second division common path 21b of the first common path CEX11. In the third division path 31 of the first gas-exhaust path EX1, the chambers CH11 to CH16 can share the path extending from the portion communicating with the chamber CH16 to the portion connected to the third division common path 31b of the first common path CEX11.

Similarly, in the second gas-exhaust path EX2, the chambers CH21 to CH26 belonging to the second group Gr2 can share a path CEX2 extending from the portions communicating with the chamber CH26 being arranged at the highest level and belonging to the second group Gr2 to the portions connected to the first common path CEX11.

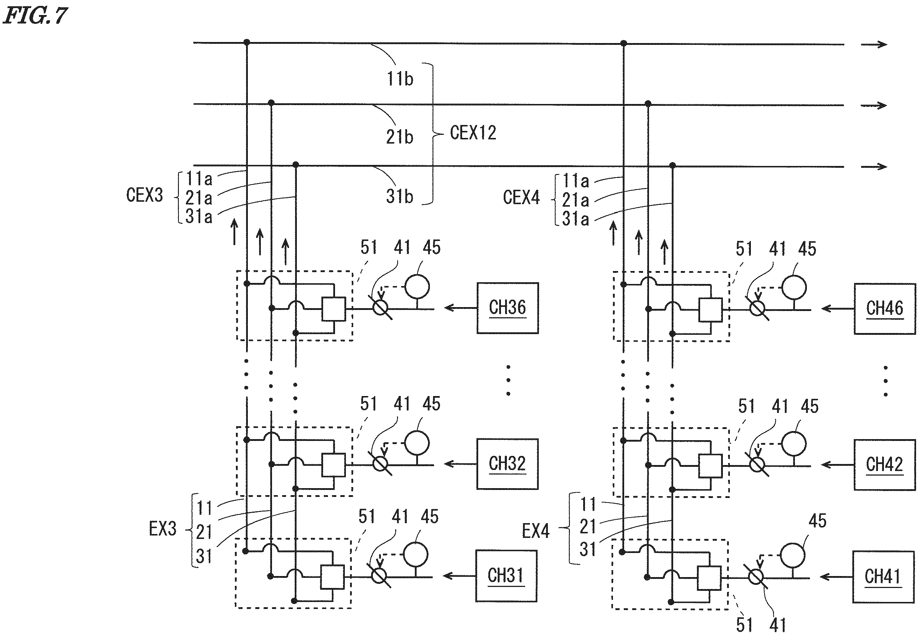

Fig. 7 is a system diagram of the third gas-exhaust path and the fourth gas-exhaust path. With reference to Fig. 7, each of the chambers CH31 to CH36 belonging to the third group Gr3 communicates with the third gas-exhaust path EX3. The gas-exhaust damper 41 and the second pressure sensor PG2 are provided between each of the chambers CH31 to CH36 and the third gas-exhaust path EX3. The switching device 51 is provided between the gas-exhaust damper 41 and the first gas-exhaust path EX1. Each of the chambers CH31 to CH36 communicates with one of the first division path 11, the second division path 21 and the third division path 31 of the third gas-exhaust path EX3.

Each of the chambers CH41 to CH46 belonging to the fourth group Gr4 communicates with the fourth gas-exhaust path EX4. The gas-exhaust damper 41 and the second pressure sensor PG2 are provided between each of the chambers CH41 to CH46 and the fourth gas-exhaust path EX4. The switching device 51 is provided between the gas-exhaust damper 41 and the second gas-exhaust path EX2. Each of the chambers CH41 to CH46 communicates with one of the first division path 11, the second division path 21 and the third division path 31 of the fourth gas-exhaust path EX4.

The third gas-exhaust path EX3 is connected to a second common path CEX12. The first division path 11 of the third gas-exhaust path EX3 is connected to the first division common path 11b of the second common path CEX12, the second division path 21 of the third gas-exhaust path EX3 is connected to the second division common path 21b of the second common path CEX12, and the third division path 31 of the third gas-exhaust path EX3 is connected to the third division common path 31b of the second common path CEX12.

The fourth gas-exhaust path EX4 is connected to the second common path CEX12. The first division path 11 of the fourth gas-exhaust path EX4 is connected to the first division common path 11b of the second common path CEX12, the second division path 21 of the fourth gas-exhaust path EX4 is connected to the second division common path 21b of the second common path CEX12, and the third division path 31 of the fourth gas-exhaust path EX4 is connected to the third division common path 31b of the second common path CEX12.

An exhaust force is applied to the second common path CEX12 from the exhaust-force generation device in the factory. In the third gas-exhaust path EX3, the chambers CH31 to CH36 belonging to the third group Gr3 can share a path CEX3 extending from the portions communicating with the chamber CH36 being arranged at the highest level and belonging to the third group Gr3 to the portions connected to the second common path CEX12.

In the first division path 11 of the third gas-exhaust path EX3, the chambers CH31 to CH36 can share the path extending from the portion communicating with the chamber CH36 to the portion connected to the first division common path 11b of the second common path CEX12. In the second division path 21 of the third gas-exhaust path EX3, the chambers CH31 to CH36 can share the path extending from the portion communicating with the chamber CH16 to the portion connected to the second division common path 21b of the second common path CEX12. In the third division path 31 of the third gas-exhaust path EX3, the chambers CH31 to CH36 can share the path extending from the portion communicating with the chamber CH36 to the portion connected to the third division common path 31b of the second common path CEX12.

Similarly, in the fourth gas-exhaust path EX4, the chambers CH41 to CH46 belonging to the fourth group Gr4 can share a path CEX4 extending from the portions communicating with the chamber CH46 being arranged at the highest level and belonging to the fourth group Gr4 to the portions connected to the second common path CEX12.

While substrate cleaning units are described as one example of a plurality of substrate processing units WU included in the substrate processing apparatus 1 in the present embodiment, the plurality of substrate processing units WU may be photosensitive film forming units, peripheral edge exposure units, developing units and the like, or may be a mixture of them.

### 3. Outline of Substrate Processing Apparatus Management System

Returning to Fig. 1, the substrate processing apparatus 1 includes a gas supply-exhaust system AES for maintaining cleanliness of an atmosphere in the chamber CH11 of the substrate processing unit WU11. The gas supply-exhaust system AES includes the gas supplier FFU and the gas exhauster ED included in each substrate processing unit WU. The substrate processing apparatus 1 includes a control device 10. The control device 10 controls the gas supplier FFU and the gas exhauster ED for each of the plurality of substrate processing units WU. The control device 10 includes a first controller 10a for controlling the gas supplier FFU of the each of the substrate processing units WU and a second controller 10b for controlling the gas exhauster ED of each of the substrate processing units WU.

It is necessary that the substrate processing unit WU is held with a constant pressure in order to prevent splashing of particles due to turbulence in the chamber CH. As such, the first controller 10a of the control device 10 controls the gas supplier FFU in order to set a value for the first control pressure to a predetermined pressure value (hereinafter referred to as a first target pressure value). Further, the second controller 10b of the control device 10 controls the gas exhauster ED in order to set a value for the second control pressure to a predetermined pressure value (hereinafter referred to as a second target pressure value).

In the present embodiment, the first controller 10a performs PID (Proportional-Integral-Derivative) control of electric power supplied to the fan motor of the gas supplier FFU based on the difference between the first control pressure and the first target pressure value in order to maintain a constant pressure of gas supplied into the chamber CH. Thus, the pressure of gas supplied into the chamber CH11 is maintained constant.

Further, the second controller 10b performs PID control of electric power supplied to the damper motor of the gas exhauster ED based on the difference between the second control pressure and the second target pressure value in order to maintain a constant pressure of gas exhausted from the chamber CH. Thus, the pressure of gas exhausted from the chamber CH11 is maintained constant. The pressure in the chamber CH is maintained constant by the above-mentioned control by the first controller 10a and the second controller 10b.

The six substrate processing units WU11 to WU16 belonging to the first group Gr1 are configured to be able to share the first gas-exhaust path EX1, the six substrate processing units WU21 to WU26 belonging to the second group Gr2 are configured to be able to share the second gas-exhaust path EX2, the six substrate processing units WU31 to WU36 belonging to the third group are configured to be able to share the third gas-exhaust path EX3, and the six substrate processing units WU41 to WU46 belonging to the fourth group Gr4 are configured to be able to share the fourth gas-exhaust path EX4. An exhaust force is applied to each of the first gas-exhaust path EX1 to the fourth gas-exhaust path EX4. Exhaust forces to be respectively applied to the first gas-exhaust path EX1 to the fourth gas-exhaust path EX4 may be different.

For example, although the first gas-exhaust path EX1 is designed to receive an exhaust force with which gas can be exhausted from all of the six substrate processing units WU11 to WU16 belonging to the first group Gr1, an exhaust force may change. Further, respective exhaust forces required in the respective six substrate processing units WU11 to WU16 belonging to the first group Gr1 are not necessarily the same.

In the gas supplier FFU, individual differences may be generated in regard to the responsiveness of the fan of the gas supplier FFU, an actual rotation speed of the fan with respect to an operation amount of the gas supplier FFU (a rotation speed designated by a control signal), and the like, due to the feedback control performed by the first controller 10a, differences in installation positions of the respective substrate processing units WU11 to WU16 and the like. Further, in the gas exhauster ED, the openings of the gas-exhaust damper 41 or the like may be different due to the feedback control performed by the second controller 10b, differences in installation positions of the respective substrate processing units WU11 to WU16, and the like. Thus, the characteristics of the first group Gr1 to the fourth group Gr4 of the substrate processing apparatus 1 are different from one another.

### 4. Processing Information

In the substrate processing apparatus 1, as information for management of an abnormality in the substrate processing apparatus 1, a plurality of processing information pieces representing the work or state relating to supply of gas and exhaust of gas in the substrate processing apparatus 1 are defined. In the present embodiment, as indicated by the thick arrows in Fig. 1, these processing information pieces are transmitted from the control device 10 of the substrate processing apparatus 1 to the information analysis device 3 through the management device 4 in a predetermined cycle. The processing information pieces may be transmitted from the control device 10 to the management device 4 in real time. Further, the processing information pieces may be transmitted from the control device 10 to a computer different from the management device 4 and may be transmitted from the computer to the management device 4.

The processing information pieces transmitted from the substrate processing apparatus 1 to the information analysis device 3 through the management device 4 include "a. FIRST CONTROL PRESSURE," "b. WORK AMOUNT," "d. SECOND CONTROL PRESSURE," "e. OPENING," "f. TYPE OF GAS- EXHAUST PATH" AND "g. TYPE OF PROCESSING RECIPE."

"a. FIRST CONTROL PRESSURE" is an internal pressure value of the gas supplier FFU and is a value measured by the second pressure sensor PG2. "b. WORK AMOUNT" indicates a rotation speed of the fan of the gas supplier FFU. "c. OPERATION AMOUNT" is a value of electric power applied to the fan motor of the gas supplier FFU. "d. SECOND CONTROL PRESSURE" is a gas-exhaust pressure value of the chamber CH11 and is a value measured by the second pressure sensor PG2. "e. OPENING" is a value indicating an opening of the gas-exhaust damper 41 of the gas exhauster ED. "f. TYPE OF GAS EXHAUST PATH" indicates one of the first division path 11, the second division path 21 and the third division path 31 included in the gas-exhaust path. "g. TYPE OF PROCESSING RECIPE" indicates the type of a processing recipe which is a condition for processing substrates by the substrate processing units WU. In this manner, in the present embodiment, the processing information pieces relating to the gas supplier FFU and the gas exhauster ED are shown.

### 5. State Detection Work of Substrate Processing Apparatus

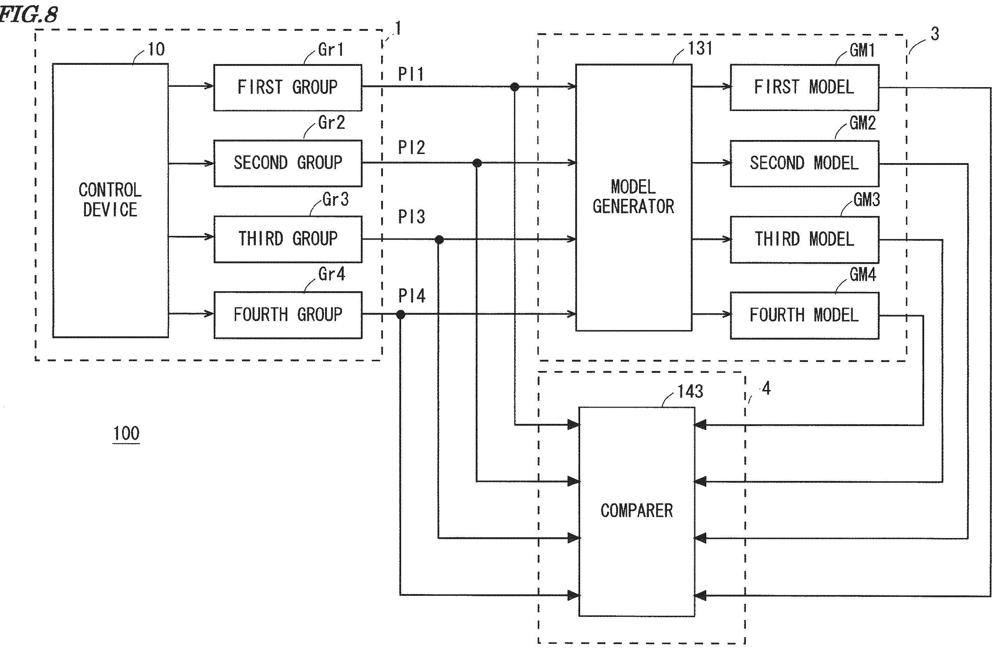

Fig. 8 is a conceptual diagram for explaining the work of the substrate processing apparatus management system. With reference to Fig. 8, in the substrate processing apparatus management system 100 in the present embodiment, the plurality of substrate processing units WU included in the substrate processing apparatus 1 are classified into one of a plurality of groups. In the present embodiment, the plurality of substrate processing units WU sharing the gas-exhaust path are classified into the same group.

In the substrate processing apparatus management system 100, the correlations in regard to a plurality of processing information pieces respectively corresponding to a plurality of substrate processing units WU belonging to the same group in a state in which the plurality of substrate processing units WU are working normally are determined in advance. Then, the correlations in regard to a plurality of processing information pieces respectively collected from the plurality of processing units belonging to the same group are compared with the predetermined correlations for the group, and the state of the gas supply-exhaust system as a whole for the plurality of substrate processing units WU corresponding to the group is determined based on the comparison result. In Fig. 2, PI1 to PI4 correspond to the first group Gr1 to the fourth group Gr4, respectively, and represent the processing information pieces respectively corresponding to the plurality of substrate processing units WU belonging to each group.

The information analysis device 3 generates a machine learning model corresponding to the group (group correlations) by executing machine learning using the processing information pieces corresponding to the group. Specifically, the information analysis device 3 defines a plurality of combinations each of which includes two different processing information pieces, and derives the correlation between the two processing information pieces forming each combination as an invariant relationship. For example, the correlation between two processing information pieces is expressed by a function in which one processing information piece takes the other processing information piece as a variable and a function in which the other processing information piece takes the one processing information piece as a variable. An invariant relationship derived by the information analysis device 3 when the information analysis device 3 executes machine learning on a plurality of processing information pieces is a model.

The information analysis device 3 generates a first model GM1 corresponding to the first group Gr1 by executing machine learning using the processing information pieces PI1 corresponding to the first group Gr1. Similarly, the information analysis device 3 generates a second model GM2 using the processing information pieces PI2 corresponding to the second group Gr2, generates a third model GM3 using the processing information pieces PI3 corresponding to the third group Gr3, and generates a fourth model GM4 by using the processing information pieces PI4 corresponding to the fourth group Gr4.

Using the processing information pieces PI1 corresponding to the first group Gr1, the management device 4 compares the correlation between two processing information pieces forming each combination with the invariant relationship defined by the first model GM1 in regard to each of a plurality of combinations each of which includes two different information pieces. Specifically, the management device 4 calculates degrees of deviation from the first model GM1 as deviation degrees by using the processing information pieces PI1 corresponding to the first group Gr1. Further, based on the calculated deviation degrees, the management device 4 calculates a degree of abnormality of the first group Gr1 as an abnormality score. That is, in a case in which the abnormality score is low, it indicates that the substrate processing units WU11 to WU16 belonging to the first group Gr1 are working similarly to the first model GM1, and that the gas supply-exhaust system AES is working normally. In a case in which the abnormality score is high, it indicates that the substrate processing units WU11 to WU16 belonging to the first group Gr1 are working differently from the first model GM1. Because the first model GM1 represents the state in which the substrate processing units WU11 to WU16 belonging to the first group Gr1 are working normally, in a case in which the substrate processing units WU11 to WU16 belonging to the first group Gr1 are working differently from the first model GM1, it is considered that the gas supply-exhaust system AES is likely to be abnormal.

### <Example of Calculation of Abnormality Score>

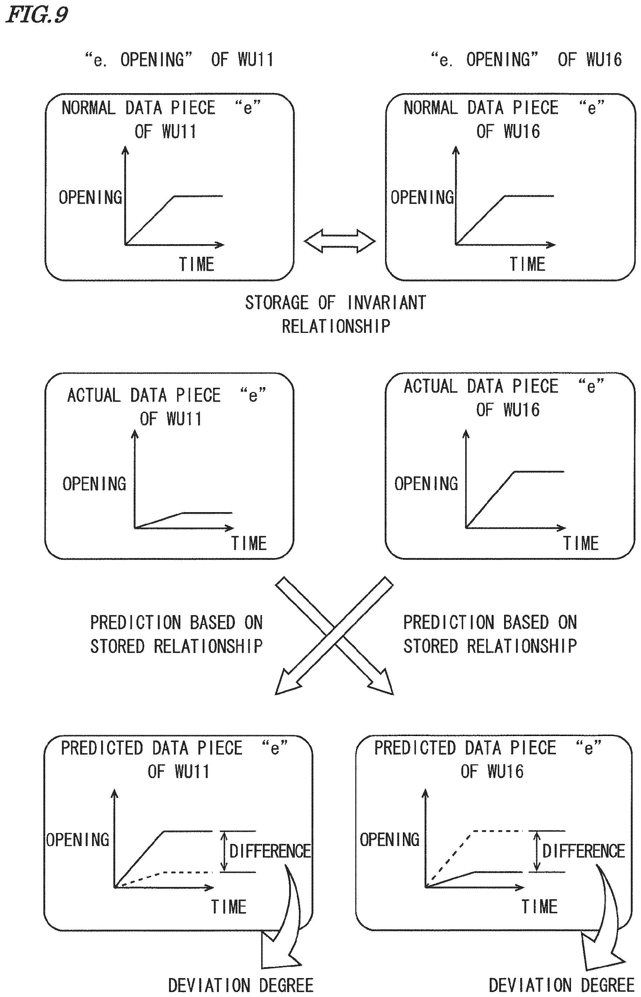

Next, a specific example of a method of calculating an abnormality score will be described. The first model GM1 to the fourth model GM4 define correlations for a plurality of combinations each of which includes two different processing information pieces. In order to calculate an abnormality score of a group, the deviation degrees in regard to the processing information pieces corresponding to the group are calculated. Fig. 9 is a diagram for explaining the specific example of calculation of a deviation degree. Here, the example of calculation of the deviation degree corresponding to the combination of "e. OPENING" of the substrate processing unit WU11 and "e. OPENING" of the substrate processing unit WU16 belonging to the first group Gr1 is described. In the following description, the data of "e. OPENING" is suitably referred to as a data piece "e."

In order to calculate the deviation degree, the reference data representing the invariant relationship between "e. OPENING" of the substrate processing unit WU11 and "e. OPENING" of the substrate processing unit WU16 is required. As such, the management device 4 stores the first model GM1 generated by the information analysis device 3 before a process is actually executed on the substrate W in the substrate processing apparatus 1. The first model GM1 defines the correlation between the data piece "e" of the substrate processing unit WU11 and the data piece "e" of the substrate processing unit WU16 when the substrate processing units WU11 to WU16 belonging to the first group Gr1 are working normally.

The first model GM1 is generated by the information analysis device 3 based on the processing information pieces PI1 respectively corresponding to the plurality of substrate processing units WU11 to WU16 belonging to the first group Gr1 when the substrate processing apparatus 1 is working actually normally, for example.

In the upper portion of Fig. 9, one example of the temporal changes of the data piece "e" of the substrate processing unit WU11 and the data piece "e" of the substrate processing unit WU16 of the first model GM1 is shown by the graphs. In the graph for the data piece "e," the abscissa indicates time, and the ordinate indicates an opening of the gas-exhaust damper 41.

According to the two graphs in the upper portion of Fig. 9, it is found that a value for the opening of the gas-exhaust damper 41 of the substrate processing unit WU16 increases at a substantially constant rate as a value for the opening of the gas-exhaust damper 41 of the substrate processing unit WU11 increases. That is, a value for the opening of the gas-exhaust damper 41 of the substrate processing unit WU11 and a value for the opening of the gas-exhaust damper 41 of the substrate processing unit WU16 have a correlation. In a case in which the plurality of substrate processing units WU11 to WU16 belonging to the first group Gr1 work normally, the correlation for each combination in regard to the plurality of processing information pieces respectively corresponding to the substrate processing units WU11 to WU16 is equal to the correlation defined by the first model GM1.

In this state, the substrate W is processed in each of the substrate processing unit WU11 and the substrate processing unit WU16, and actual data pieces "e" are collected by the management device 4. In the center portion of Fig. 9, one example of the temporal changes of the data piece "e" of the substrate processing unit WU11 and the data piece "e" of the substrate processing unit WU16 is shown by the graphs.

The correlation between the data piece "e" of the substrate processing unit WU11 and the data piece "e" of the substrate processing unit WU16 is compared with the correlation between the data piece "e" of the substrate processing unit WU11 and the data piece "e" of the substrate processing unit WU16 of the first model GM1. Specifically, based on the first model GM1, the data piece "e" of the substrate processing unit WU11 is predicted with reference to the data piece "e" of the substrate processing unit WU16. In other words, based on the correlation of the data piece "e" of the substrate processing unit WU11 with the data piece "e" of the substrate processing unit WU16 defined by the first model GM1, the data piece "e" of the substrate processing unit WU11 is predicted with reference to the data piece "e" of the substrate processing unit WU16. Further, based on the first model GM1, the data piece "e" of the substrate processing unit WU16 is predicted with reference to the data piece "e" of the substrate processing unit WU11. In other words, based on the correlation between the data piece "e" of the substrate processing unit WU16 with the data piece "e" of the substrate processing unit WU11 defined by the first model GM1, the data piece "e" of the substrate processing unit WU16 is predicted with reference to the data piece "e" of the substrate processing unit WU11.

In the lower portion of Fig. 9, one example of the temporal changes of the data piece "e" of the substrate processing unit WU11 and the data piece "e" of the substrate processing unit WU16 that are predicted based on the first model GM1 is shown by the graphs. In the graphs in the lower portion of Fig. 9, the predicted data piece "e" of the substrate processing unit WU11 and the predicted data piece "e" of the substrate processing unit WU16 are indicated by the solid lines, and the data piece "e" of the substrate processing unit WU11 and the data piece "e" of the substrate processing unit WU16 are indicated by the dotted lines.

In a case in which the substrate processing units WU11 to WU16 are working similarly to the first model GM1, the data piece "e" of the substrate processing unit WU11 and the predicted data piece "e" of the substrate processing unit WU11 coincide or substantially coincide with each other. Further, the data piece "e" of the substrate processing unit WU16 and the predicted data piece "e" of the substrate processing unit WU16 coincide or substantially coincide with each other.

However, in a case in which at least one of the substrate processing units WU11 to WU16 is working differently from the first model GM1, the data piece "e" of the substrate processing unit WU11 and the predicted data piece "e" of the substrate processing unit WU11 are likely to deviate from each other. Further, the data piece "e" of the substrate processing unit WU16 and the predicted data piece "e" of the substrate processing unit WU16 are likely to deviate from each other.

It is considered that, the larger a degree of difference between the work of the substrate processing units WU11 to WU16 and the work of the substrate processing units WU11 to WU16 in the first model GM1, the larger a degree of deviation. Further, the smaller a degree of difference between the work of the substrate processing units WU11 to WU16 and the work of the substrate processing units WU11 to WU16 in the first model, the smaller a degree of deviation.

As such, in the present embodiment, in regard to each of the processing information pieces PI1 corresponding to the first group Gr1, a value of difference from a predicted value that is predicted based on the first model GM1 is calculated as a deviation degree. In the example of Fig. 9, when calculating a deviation degree at a certain point in time, the management device 4 calculates the value of difference between the data piece "e" of the substrate processing unit WU11 of the first group Gr1 and the predicted data piece "e" of the substrate processing unit WU11 as a deviation degree. Further, the management device 4 calculates the value of difference between the data piece "e" of the substrate processing unit WU16 of the first group Gr1 and the predicted data piece "e" of the substrate processing unit WU16 as a deviation degree.

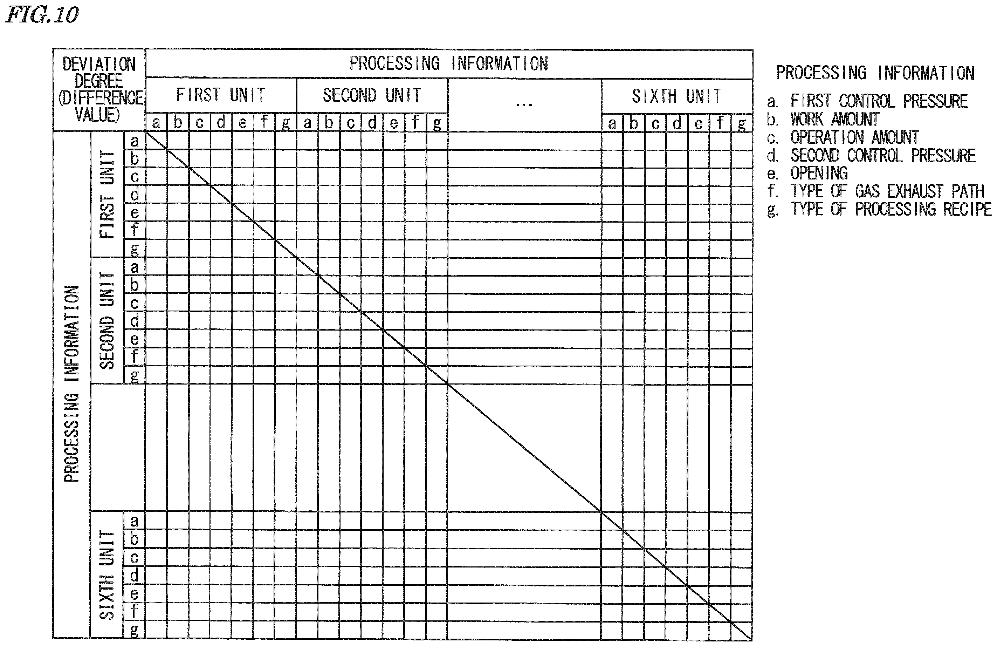

Fig. 10 is a diagram showing one example of a deviation-degree table. A deviation-degree table is the table representing the deviation degree for each of all combinations in regard to processing information pieces. The management device 4 calculates the above-mentioned deviation degrees for all combinations in regard to the processing information pieces. With reference to Fig. 10, the first to sixth units in the left column of the deviation-degree table indicate the substrate processing units WU11 to WU16. In the left column, processing information pieces "a" to "g" are defined for each of the first to sixth units. The first to sixth units in the upper row of the deviation-degree table indicate the substrate processing units WU11 to WU16. In the row, processing information pieces "a" to "g" are defined for each of the first to sixth units.

For example, each of the plurality of values arranged in the row at the right of the processing information piece "a" of the first unit in the left column of the deviation-degree table represents the deviation degree between the processing information piece predicted based on each of the processing information pieces "a" to "g" of the first to sixth units in the upper row, and an actually acquired processing information piece.

Each of the plurality of values arranged in the column below the processing information piece "a" in the upper row of the deviation-degree table represents the deviation degree between the processing information piece predicted based on each of "a" to "g" of the first to sixth units in the left column, and an actually acquired processing information piece.

The deviation-degree table shown in Fig. 10 represents the plurality of deviation degrees calculated for all of combinations in regard to the processing information pieces relating to the substrate processing units WU1 to WU6 belonging to the first group Gr1.

An abnormality score is calculated based on the deviation-degree table. In the present embodiment, the abnormality score is calculated for each of the first group Gr1 to the sixth group Gr6. For example, the first group Gr1 will be described. The deviation-degree table shown in Fig. 10 is generated in correspondence with the first group Gr1. In the present embodiment, it is detected that, although not being abnormal, the work or state in regard to exhaust of gas in each of the substrate processing units WU11 to WU16 belonging to the first group Gr1 is to become abnormal if they continue to work in a current manner. Specifically, based on the correlation in regard to an opening of the gas-exhaust damper 41 for each of the substrate processing units WU11 to WU16, a state prior to the state in which an abnormality occurs is detected.

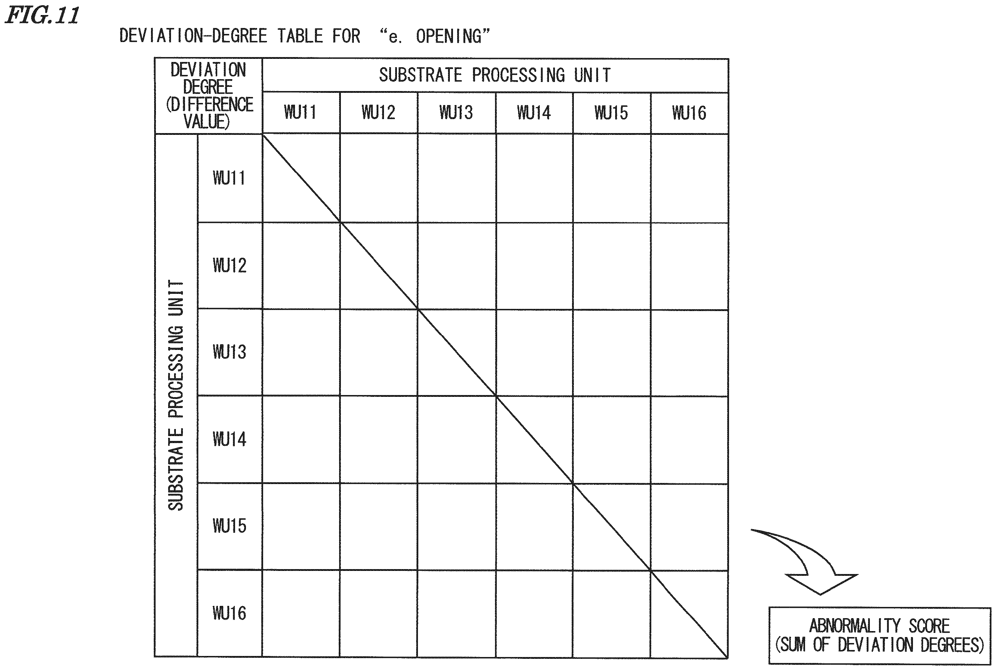

Fig. 11 is a diagram showing one example of the deviation-degree table for "e. OPENING." The deviation-degree table for "e. OPENING" shown in Fig. 11 is obtained when the row and column for "e. OPENING" are extracted from the deviation degrees shown in the deviation-degree table shown in Fig. 10.

Each deviation degree shown in the deviation-degree table for "e. OPENING" indicates the difference between the correlation in regard to an opening for each of the substrate processing units WU11 to WU16 and the correlation in regard to an opening for each of the substrate processing units WU11 to WU16 in a normal state.

The sum of the plurality of deviation degrees shown in the deviation-degree table for "e. OPENING" corresponding to the first group Gr1 in Fig. 11 is calculated as the abnormality score corresponding to the first group Gr1.

6. One Example of Functional Configuration of Substrate Processing Apparatus Management System

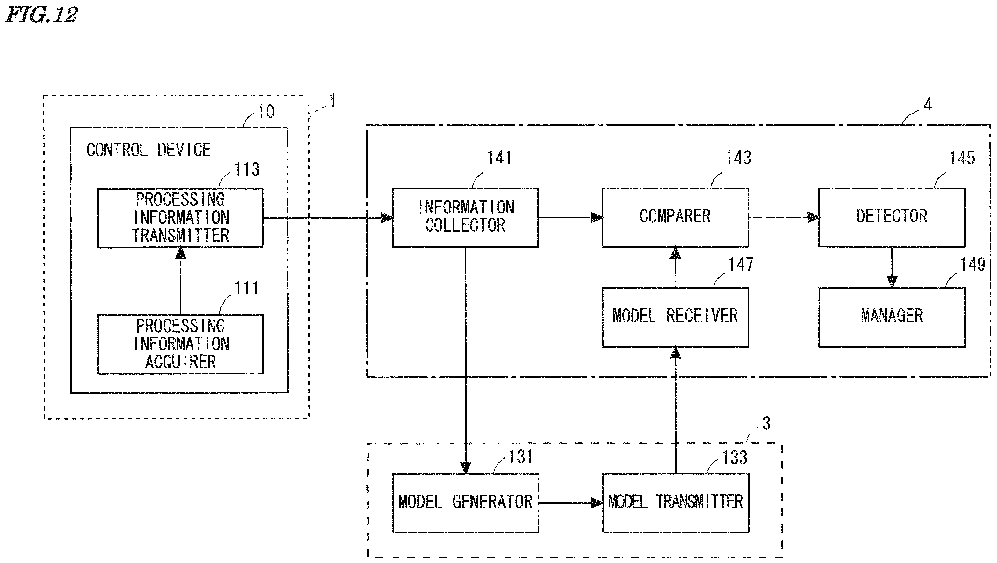

Fig. 12 is a block diagram for explaining one example of the functional configurations of the substrate processing apparatus management system. With reference to Fig. 12, the control device 10 included in the substrate processing apparatus 1 includes a processing information acquirer 111 and a processing information transmitter 113. The functions of the control device 10 are implemented when the CPU included in the control device 10 executes a control program stored in a memory.

The processing information acquirer 111 acquires processing information pieces from each of the plurality of substrate processing units WU. Here, the processing information pieces include "a. FIRST CONTROL PRESSURE," "e. OPENING," "d. SECOND CONTROL PRESSURE," "b. WORK AMOUNT," "c. OPERATION AMOUNT," "f. TYPE OF GAS-EXHAUST PATH" AND "g. TYPE OF PROCESSING RECIPE." The processing information acquirer 111 acquires the processing information pieces from each of the 24 substrate processing units WU at predetermined time intervals. Therefore, the processing information pieces acquired from the substrate processing units WU are time-series data pieces in which values are defined for each of points in time that are defined according to the predetermined time intervals. The processing information transmitter 113 transmits the plurality of processing information pieces acquired from each of the 24 substrate processing units WU to the management device 4.

The management device 4 includes an information collector 141, a comparer 143, a detector 145, a model receiver 47 and a manager 149. The functions of the management device 4 are implemented when the CPU included in the management device 4 executes a substrate processing apparatus management program stored in the memory.

The information collector 141 collects the processing information pieces representing the work and state in regard to supply and exhaust of gas in a period during which each of the plurality of substrate processing units WU processes a substrate. The information collector 141 receives the plurality of processing information pieces corresponding to each of the plurality of substrate processing units WU from the control device 10, outputs the plurality of received processing information pieces to the comparer 143, and transmits the plurality of received processing information pieces to the information analysis device 3.

The model receiver 47 receives the first model GM1 to the fourth model GM4 respectively corresponding to the first group Gr1 to the fourth group Gr4 from the information analysis device 3 and outputs the received first model GM1 to fourth model GM4 to the comparer 143. The first model GM1 to the fourth model GM4 define the correlations in regard to the processing information pieces PI1 to PI4 respectively corresponding to the first group Gr1 to the fourth group Gr4.

For each of the first group Gr1 to the fourth group Gr4, the comparer 143 compares the correlations in regard to the processing information pieces corresponding to the group with the correlations in regard to the model corresponding to the group, and outputs a comparison result to the detector 145. The comparison in regard to the first group Gr1 will be described, by way of example. The comparer 143 receives the processing information pieces PI1 corresponding to the first group Gr1 from the information collector 141, and receives the first model GM1 corresponding to the first group Gr1 from the model receiver 47. The processing information pieces PI1 include the data pieces "a" to "h" for each of the substrate processing units WU11 to WU16.

Using the first model GM1, the comparer 143 calculates the predicted value corresponding to each of the data pieces "a" to "h" for each of the substrate processing units WU11 to WU16 included in the processing information pieces PI1. Then, the comparer 143 calculates the difference between each of the data pieces "a" to "h" and its predicted value for each of the substrate processing units WU11 to WU16 as a deviation degree. Thus, the deviation-degree table shown in Fig. 10 is generated. The comparer 143 outputs the deviation-degree table to the detector 145.

For each of the first group Gr1 to the fourth group Gr4, the detector 145 compares the correlations in regard to the processing information pieces corresponding to the group and relating to exhaust of gas with the correlations in regard to the model corresponding to the group, and calculates an abnormality score. Here, the first group Gr1 will be described, by way of example. The deviation degree for "e. OPENING" is extracted from the deviation-degree table received from the comparer 143, and the sum of the extracted deviation degrees is calculated as the abnormality score of the first group Gr1.

Based on the abnormality score calculated for each of the first group Gr1 to the fourth group Gr4, the detector 145 detects the group that is predicted to have an abnormality. For example, in regard to each of the first group Gr1 to the fourth group Gr4, the detector 145 compares the abnormality score with a predetermined threshold value. The detector 145 determines that the group having an abnormality score equal to or larger than the threshold value among the first group Gr1 to the fourth group Gr4 is predicted to have an abnormality. In regard to the group having an abnormality score equal to or larger than the threshold value, it is predicted that, although not currently being abnormal, the work or state relating to exhaust of gas for each of the plurality of substrate processing units belonging to the group may become abnormal if they continue to work in a current manner (hereinafter referred to as a "pre-abnormality state.")

The manager 149 generates management information relating to the countermeasure for a group that is detected to be in the pre-abnormality state by the detector 145. Here, the first group Gr1 is determined as a subject group that is detected to be in the pre-abnormality state, by way of example. For example, the manager 149 generates management information including an instruction for closing the gas-exhaust damper 41 of a unit that is not processing the substrate W among the substrate processing units WU11 to 16 belonging to the first group Gr1. The manager 149 may transmit the management information to the substrate processing apparatus 1 to control the substrate processing apparatus 1. In this case, the substrate processing apparatus 1 closes the gas-exhaust damper 41 of a unit that is not processing the substrate W among the substrate processing units WU11 to WU16 belonging to the first group Gr1.

Further, the manager 149 generates management information including an instruction for putting back the damper position of the gas exhauster ED and the number of rotations of the fan motor of the gas supplier FFU of each of the substrate processing units WU11 to 16 belonging to the first group Gr1 to initial values. The manager 149 may transmit the management information to the substrate processing apparatus 1 to control the substrate processing apparatus 1. In this case, the substrate processing apparatus 1 puts back the damper position of the gas exhauster ED and the number of rotations of the fan motor of the gas supplier FFU in each of the substrate processing units WU11 to WU16 belonging to the first group Gr1 to the initial values.

Further, the manager 149 generates management information including group identification information for identifying the first group Gr1 determined as a subject group, and notifies an administrator of the management information. Thus, the administrator is notified that the control of supply of gas or exhaust of gas in each of the substrate processing units WU11 to 16 belonging to the first group Gr1 needs to be changed.

Further, the manager 149 generates management information including a plurality of deviation degrees calculated by the comparer 143 for the first group Gr1 and notifies the administrator of the management information. For example, the manager 149 notifies the administrator of the deviation-degree table shown in Fig. 10 as the management information. Thus, the administrator can be notified of the information for adjusting the control of the supply of gas or the exhaust of gas in each of the substrate processing units WU11 to WU16 belonging to the first group Gr1.

In order to notify the administrator of the management information, the manager 149 may display the management information on a display included in the management device 4 or may transmit an electronic mail including the management information to the administrator.

The information analysis device 3 includes a model generator 131 and a model transmitter 133. The functions of the information analysis device 3 are implemented when the CPU included in the information analysis device 3 executes a model generation program stored in the memory.

Using the processing information pieces PI1 to PI4 collected by the information collector 141, the model generator 131 generates the first model GM1 to the fourth model GM4 respectively corresponding to the first group Gr1 to the fourth group Gr4. The processing information pieces PI1 to PI4 used when the model generator 44 generates the first model GM1 to the fourth model GM4 are collected by the information collector 141 in a period during which the substrate processing apparatus 1 is working normally.

The model generator 44 generates the first model GM1 by executing machine learning on the processing information pieces PI1 for the substrate processing units WU11 to WU16 belonging to the first group Gr1. Specifically, the processing information pieces PI1 include the plurality of data pieces "a" to "h" for each of the substrate processing units WU11 to WU16. The model generator 131 learns the correlation for each set including two different data pieces among a plurality of data pieces included in the processing information pieces PI1.

Similarly, the model generator 44 generates the second model GM2 by executing machine learning on the processing information pieces PI2 for the substrate processing units WU21 to WU26 belonging to the second group Gr2. The processing information pieces PI1 include the plurality of data pieces "a" to "h" for each of the substrate processing units WU21 to WU26. The model generator 44 generates the third model GM3 by executing machine learning on the processing information pieces PI3 for the substrate processing units WU31 to WU36 belonging to the third group Gr3. The processing information pieces PI3 include the plurality of data pieces "a" to "h" for each of the substrate processing units WU31 to WU36. The model generator 44 generates the fourth model GM4 by executing machine learning on the processing information pieces PI4 for the substrate processing units WU41 to WU46 belonging to the fourth group Gr4. The processing information pieces PI4 include the plurality of data pieces "a" to "h" for each of the substrate processing units WU41 to WU46.

The model generator 131 outputs the generated first model GM1 to the generated fourth model GM4 to the model transmitter 133. The model transmitter 133 transmits the first model GM1 to the fourth model GM4 to the management device 4.

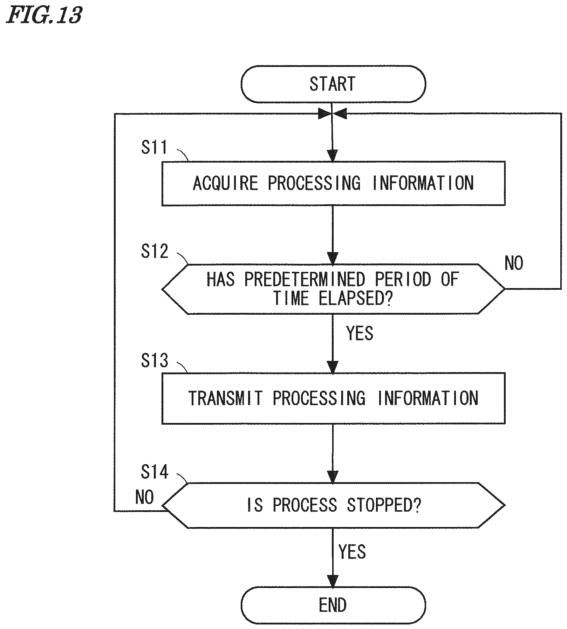

Fig. 13 is a flowchart showing one example of a flow of a processing information transmission process. The processing information transmission process is a process executed by the CPU included in the control device 10 of the substrate processing apparatus 1 when the CPU executes a processing information transmission program stored in the memory. With reference to Fig. 13, the control device 10 acquires the processing information pieces for each of the plurality of substrate processing units WU (step S11). The control device 10 acquires the processing information pieces PI1 including the data pieces "a" to "h" for each of the substrate processing units WU11 to WU16 belonging to the first group Gr1 in a predetermined cycle, for example.

In the next step S12, whether a predetermined period of time has elapsed is determined. The predetermined period of time can be arbitrarily defined as a period equal to or larger than the predetermined cycle. If the predetermined period of time has elapsed, the process proceeds to the step S13. If not, the process returns to the step S11. In a case in which the predetermined cycle is repeated multiple times in the predetermined period of time, the number of groups each of which includes the processing information pieces PI1 corresponds to the number of repetitions of the predetermined cycle.

The process of the step S11 and the step S12 are executed on all of the plurality of substrate processing units WU. Therefore, the processing information pieces PI1 to PI4 respectively corresponding to the first group Gr1 to the fourth group Gr4 are acquired.

In the step S13, the processing information pieces are transmitted. The processing information pieces corresponding to all of the plurality of substrate processing units WU are transmitted to the management device 4, and the process proceeds to the step S14. In the step S14, whether the process executed by the substrate processing apparatus 1 is stopped is determined. If the process is stopped, the process ends. If not, the process returns to the step S11.

Therefore, in a period during which the substrate processing apparatus 1 processes a substrate, the processing information pieces PI1 to PI4 respectively corresponding to the first group Gr1 to the fourth group Gr4 are transmitted to the management device 4. Instead of transmission of the processing information pieces PI1 to PI4 each time the predetermined period of time elapses, after a period longer than the predetermined period of time has elapsed, such as a point in time designated by the administrator of the substrate processing apparatus 1, the processing information pieces PI1 to PI4 that have been collected till then may be collectively transmitted.

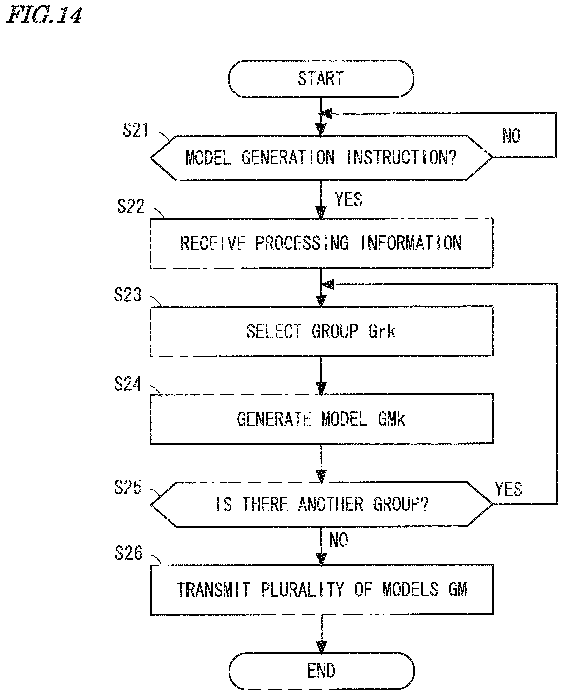

Fig. 14 is a flowchart showing one example of a flow of a model generation process. The model generation process is a process executed by the CPU included in the information analysis device 3 when the CPU executes a model generation program stored in the memory. With reference to Fig. 14, the CPU included in the information analysis device 3 determines whether a model generation instruction has been accepted (step S21). The process waits until the model generation instruction is accepted (NO in the step S21). If the model generation instruction is accepted (YES in the step S21), the process proceeds to the step S22.

In the step S22, the processing information pieces for all of the plurality of substrate processing units WU are received, and the process proceeds to the step S23. Transmission of the processing information pieces for all of the plurality of substrate processing units WU to the management device 4 is requested, and the processing information pieces transmitted from the management device 4 are received. The processing information pieces are collected by the management device 4 in a period during which the substrate processing apparatus 1 works normally.

In the step S23, a group Grk (k is a positive integer) to be subjected to a process is selected from among the first group Gr1 to the fourth group Gr4, and the process proceeds to the step S24.

In the step S24, a model GMk corresponding to the group Grk to be subjected to a process is generated, and the process proceeds to the step S25. Processing information pieces Plk for each of the plurality of substrate processing units WU belonging to the group Grk are extracted from the processing information pieces for each of the plurality of substrate processing units WU received in the step S22. Machine learning is executed on the processing information pieces Plk, so that the model GMk is generated.

In the step S25, whether a group that is not selected as being subjected to a process in the step S23 among the first group Gr1 to the fourth group Gr4 is present is determined. If an unselected group is present (YES in the step S25), the process returns to the step S23. If not (NO in the step S25), the process proceeds to the step S26.

The loop from the step S23 to the step S25 is repeated, so that the first model GM1 to the fourth model GM4 respectively corresponding to the first group Gr1 to the fourth group Gr4 are generated. In the step S26, the first model GM1 to the fourth model GM4 are transmitted to the management device 4, and the process ends.

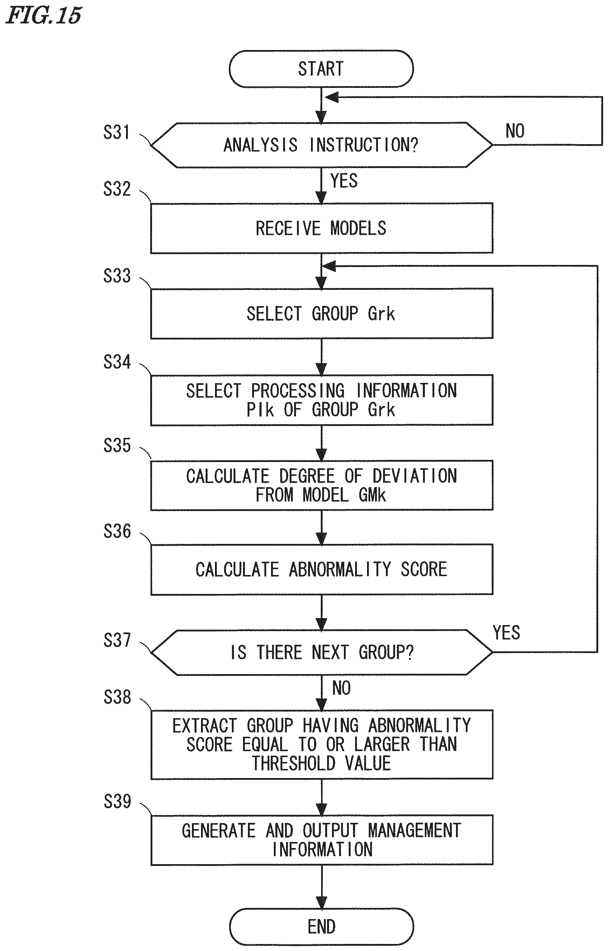

Fig. 15 is a flowchart showing one example of a flow of a substrate processing apparatus management process. The substrate processing apparatus management process is executed by the CPU included in the management device 4 when the CPU executes a substrate processing apparatus management program stored in the memory.

With reference to Fig. 15, the CPU included in the management device 4 determines whether an analysis instruction has been accepted (step S31). The process waits until an analysis instruction is accepted (NO in the step S31). If an analysis instruction is accepted (YES in the step S31), the process proceeds to the step S32. An analysis instruction may be received each time the processing information pieces PI1 to PI4 are collected. Further, the administrator of the substrate processing apparatus 1 may input an analysis instruction to the management device 4.

In the step S32, the first model GM1 to the fourth model GM4 are received, and the process proceeds to the step S33. The information analysis device 3 is requested to transmit models, and the first model GM1 to the fourth model GM4 respectively corresponding to the first group Gr1 to the fourth group Gr4 transmitted from the information analysis device 3 are received.

In the step S33, a group Grk to be subjected to an analysis is selected from among the first group Gr1 to the fourth group Gr4, and the process proceeds to the step S34. Here, k is an integer of 1 to 4. In the step S34, the processing information pieces Plk corresponding to the group Grk that is selected to be subjected to an analysis in the step S33 are selected from among the plurality of processing information pieces PI1 to PI4.

In the next step S35, a degree of deviation from the model GMk corresponding to the group Grk selected to be subjected to an analysis is calculated. Specifically, in regard to each of the data pieces "a" to "h" for each of the plurality of substrate processing units WU included in the processing information pieces Plk corresponding to the group Grk selected to be subjected to an analysis, the predicted value is obtained using the model GMk, and the difference from the predicted value is calculated as a deviation degree. Thus, the deviation-degree table shown in Fig. 10 is generated.

In the next step S36, an abnormality score is calculated. In the step S35, the sum of a plurality of deviation degrees in regard to the processing information pieces relating to exhaust of gas from among the plurality of calculated deviation degrees is calculated as an abnormality score. In the present embodiment, the deviation degrees in regard to "e. OPENING" indicating an opening of the gas-exhaust damper 41 are used as deviation degrees used for calculation of the abnormality score. For example, in regard to the first group Gr1, the sum of the deviation degrees shown in the deviation-degree table for "e. OPENING" shown in Fig. 11 is calculated as an abnormality score.

In the step S37, whether a group that is not selected to be subjected to an analysis in the step S33 is present among the first group Gr1 to the fourth group Gr4 is determined. If an unselected group is present, the process returns to the step S33. If not, the process proceeds to the step S38.

The loop from the step S33 to the step S37 is repeated, so that the abnormality score corresponding to each of the first group Gr1 to the fourth group Gr4 is calculated.

In the step S38, a group having an abnormality score equal to or larger than a threshold value is extracted from the first group Gr1 to the fourth group Gr4, and the process proceeds to the step S39. In regard to the group extracted in the step 38, it is predicted that, although not being abnormal, the work relating to exhaust of gas in each of the plurality of substrate processing units WU belonging to the group is predicted to become abnormal if they continue working in a current manner ("pre-abnormality state.") In the step S39, management information is generated to be output, and the process ends. For example, the management information includes an instruction for closing the gas-exhaust damper 41 of a unit that is not processing the substrate W among the substrate processing units WU, with the substrate processing units WU belonging to the group having an abnormality score that is equal to or larger than the threshold value among the first group Gr1 to the fourth group Gr4. In this case, the management device 4 may transmit this management information to the substrate processing apparatus 1.

Further, the management information may include an instruction for putting back the damper position of the gas exhauster ED and the number of rotations of the fan motor of the gas supplier FFU in each of the plurality of substrate processing units WU to the initial values, with the plurality of substrate processing units WU belonging to the group having an abnormality score equal to or larger than the threshold value among the first group Gr1 to the fourth group Gr4. In this case, the management device 4 may transmit this management information to the substrate processing apparatus 1.

Further, the management information may include group identification information for identifying a group having an abnormality score equal to or larger than the threshold value among the first group Gr1 to the fourth group Gr4. In this case, the management device 4 may notify the administrator of this management information. The administrator can be notified that it is necessary to adjust the control of the supply of gas or the exhaust of gas in each of the substrate processing units WU belonging to the group having an abnormality score equal to or larger than the threshold value.

Further, the management information may include the deviation-degree table calculated in the step 35 in regard to a group having an abnormality score equal to or larger than the threshold value among the first group Gr1 to the fourth group Gr4. In this case, the management device 4 may notify the administrator of the management information. The administrator can be notified of the information for adjusting the gas supplier FFU and the gas exhauster ED included in each of the plurality of processing units WU belonging to the group having an abnormality score equal to or larger than the threshold value.

### 7. Effects of Embodiments

The substrate processing apparatus management system 100 in the present embodiment includes the management device 4 that manages the substrate processing apparatus 1, and the information analysis device 3. The substrate processing apparatus 1 includes the first gas-exhaust path EX1, the second gas-exhaust path EX2 and the third gas-exhaust path EX3 to which predetermined exhaust forces are applied, and the 24 substrate processing units WU that are classified into the first group Gr11, the second group Gr2 and the third group Gr3 respectively corresponding to the first gas-exhaust path EX1, the second gas-exhaust path EX2 and the third gas-exhaust path EX3, and process the substrates W. In each of the first group Gr1, the second group Gr2 and the third group Gr3, the substrate processing units WU11 to WU16 classified into the first group Gr1, for example, are configured to be able to share the first gas-exhaust path EX1 corresponding to the first group Gr1. The information analysis device 3 includes the model generator 131 that, for example, generates the first model GM1 representing the group correlations as correlations in regard to a plurality of processing information pieces that correspond to each of the substrate processing units WU11 to WU16 classified into the first group Gr1 and representing the work or state in regard to supply and exhaust of gas. The same also applies to each of the second group Gr2 and the third group Gr3. The management device 4 includes the information collector 141 that acquires a plurality of processing information pieces corresponding to each of the plurality of substrate processing units WU, and the detector 147 that detects the state prior to the state in which any of the substrate processing units WU classified into the group becomes abnormal. For example, the detector 147 detects the state prior to the state in which any of the substrate processing units WU11 to WU16 classified into the first group Gr1 becomes abnormal, based on the comparison information that is obtained when the correlations in regard to the plurality of processing information pieces relating to exhaust of gas among the plurality of processing information pieces that correspond to each of the substrate processing units WU11 to WU16 classified into the first group Gr1 and are obtained by the information collector 141, are compared with the first model GM1 corresponding to the first group Gr1. The same also applies to the second group Gr2 and the third group Gr3.

Therefore, in a case in which the first model GM1 represents the correlations in regard to a plurality of processing information pieces obtained when each of the substrate processing units WU11 to WU16 works normally, for example, the work or state relating to exhaust of gas in each of in the substrate processing units WU11 to WU16 sharing the first gas-exhaust path EX1 can be compared with a normal state. Further, it is possible to detect that the work or state relating to exhaust of gas in each of the substrate processing units WU11 to WU16 sharing the first gas-exhaust path EX1 is different from a normal state. Therefore, in regard to the first group Gr1, it is possible to detect that, although not being abnormal, the work or state relating to exhaust of gas in each of the substrate processing units WU11 to WU16 sharing the first gas-exhaust path EX1 is to become abnormal if they continue to work in a current manner (pre-abnormal state). The same applies to the second group Gr2 and the third group Gr3. One of the plurality of substrate processing units WU becomes abnormal in a case in which the pressure in the chamber CH in any of the plurality of substrate processing units WU becomes equal to or smaller than a lower limit threshold value, for example. Therefore, because the state prior to the state in which any of the plurality of substrate processing units WU becomes abnormal is detected, it is not necessary to stop the substrate processing apparatus 1, and it is possible to reduce the working period of time and the opportunity where the throughput is reduced.

Further, in regard to each of the first group Gr1 to the fourth group Gr4, the same types of the processing information pieces are respectively acquired from the substrate processing units WU11 to WU16 belonging to the first group Gr1, for example. The types of the processing information pieces are "a. FIRST CONTROL PRESSURE," "e. WORK AMOUNT," "c. OPERATION AMOUNT," "d. SECOND CONTROL PRESSURE," "e. OPENING," "f. TYPE OF GAS-EXHAUST PATH" ad "g. TYPE OF PROCESSING RECIPE." Therefore, in regard to each of the first group Gr1 to the fourth group Gr4, because the same types of the processing information pieces are respectively acquired from the substrate processing units WU11 to WU16 belonging to the first group Gr1, the correlations in regard to the same types of the processing information pieces are compared with the correlations in regard to the same types of the processing information pieces obtained when a substrate processing unit is working normally. Therefore, comparison can be made in regard to the substrate processing units WU11 to WU16 belonging to the first group Gr1 for the same types of the processing information pieces.

Further, in regard to each of the substrate processing units WU11 to WU16 belonging to the first group Gr1, the deviation-degree information pieces are acquired. For example, in regard to the substrate processing unit WU11, the deviation-degree information pieces representing the respective degrees of deviation between the processing information pieces acquired in correspondence with the substrate processing unit WU11 and the predicted values predicted using the first model GM1 based on the processing information pieces. The same also applies to each of the second group Gr2 to the fourth group Gr4. Therefore, it is possible to compare the correlations with the correlations obtained when a substrate processing unit is working normally, with the correlations relating to the work or state for exhaust of gas in each of the substrate processing units WU11 to WU16 belonging to the first group Gr1. Because the deviation-degree information pieces representing the respective degrees of deviation between the respective predicted values and the respective processing information pieces are acquired, it is possible to represent the differences from the normal state in regard to the correlations relating to the work or state for the supply and exhaust of gas.

Further, each of the plurality of substrate processing units WU includes a gas supplier FFU that supplies gas into the substrate processing unit WU11, for example, a first pressure sensor PG1 that measures the pressure of gas supplied into the substrate processing unit WU11, a first controller 10a that controls the gas supplier such that the pressure measured by the first pressure sensor PG1 is a first target value, a gas exhauster ED including the gas-exhaust damper 41 that is connected to the first gas-exhaust path EX1 corresponding to the first group Gr1 to which the substrate processing unit WU11 belongs, and adjusts the size of the opening 43 communicating with the inner space of the substrate processing unit WU11 and the first gas-exhaust path EX1, the second pressure sensor PG2 that measures the pressure of gas exhausted from the substrate processing unit WU11, and the second controller 10b that controls the gas exhauster ED such that the pressure measured by the second pressure sensor PG2 is a second target value, and the processing information pieces include a first pressure value measured by the first pressure sensor PG1, a work amount of the gas supplier FFU, an operation amount output by the first controller 10a to the gas supplier FFU, a second pressure value measured by the second pressure sensor PG2, and an opening indicating the size of the opening output by the second controller 10b to the gas exhauster ED. Therefore, it is possible to compare a substrate processing unit working normally with another substrate processing unit in regard to the correlations for a first pressure value, a work amount of the gas supplier FFU, a second pressure value, the size of the opening of the gas exhauster ED.

Further, each of the first gas-exhaust path EX1, the second gas-exhaust path EX2, the third gas-exhaust path EX3 and the fourth gas-exhaust path EX4 includes the first division path 11, the second division path 21 and the third division path 31 that are different from one another, the gas exhauster ED includes the switching device 51 that switches to one of the first division path 11, the second division path 21 and the third division path 31, and the processing information further includes the information specifying the path, among the first division path 11, the second division path 21 and the third division path 31, connected to the substrate processing unit WU. Therefore, in regard to each of the first division path 11, the second division path 21 and the third division path 31, correlations are compared with correlations obtained when a substrate processing unit is working normally.

Further, each of the plurality of substrate processing units WU processes a substrate in accordance with any of a plurality of types of processing recipes, and processing information pieces further include information for specifying the processing recipe according to which the substrate W is processed in the substrate processing unit WU. Therefore, in regard to each of the plurality of processing recipes, a current state is compared with a normal state.

### 8. Other Embodiments

(1) While the management device 4 calculates the deviation-degree table shown in Fig. 10 in the above-mentioned embodiment, the present invention is not limited to this. The deviation-degree table for "e. OPENING" shown in Fig. 11 may be calculated without calculation of the deviation-degree table shown in Fig. 10. While "e. OPENING" is used as the processing information piece relating to the exhaust of gas by way of example, the present invention is not limited to this. As the processing information pieces relating to the exhaust of gas, "SECOND CONTROL PRESSURE" may be used in addition to "e. OPENING."
(2) While "f. TYPE OF GAS-EXHAUST PATH" and "g. TYPE OF PROCESSING RECIPE" are included in the processing information pieces in the above-mentioned embodiment, the present invention is not limited to this. The processing information pieces do not have to include "f. TYPE OF GAS-EXHAUST PATH" or "g. TYPE OF PROCESSING RECIPE." In this case, the first model GM1 to the fourth model GM4 may be generated in correspondence with "f. TYPE OF GAS-EXHAUST PATH." Further, the first model GM1 to the fourth model GM4 may be generated in correspondence with "g. TYPE OF PROCESSING RECIPE." Further, the first model GM1 to the fourth model GM4 may be generated in correspondence with the combination of "f. TYPE OF GAS-EXHAUST PATH" and "g. TYPE OF PROCESSING RECIPE."
(3) While the substrate processing apparatus 1 is a single-wafer substrate cleaning device in the above-mentioned embodiment, the present invention is not limited to this. As long as including a plurality of substrate processing units WU, the substrate processing apparatus 1 may be a batch-type substrate cleaning device instead of a single-wafer substrate cleaning device, or may have the configuration for executing a process other than a cleaning process. The plurality of substrate processing units WU may be photosensitive film forming units, edge exposure units, developing units and the like, or may be a mixture of these units.
(4) In addition to or instead of the plurality of specific examples described in the above-mentioned embodiment, a plurality of processing information pieces may include another physical quantity. A physical quantity may include at least one of the number of rotations, the rotation speed and acceleration of a motor provided in a chamber, a flow rate of gas, a temperature, a humidity, a pressure and the like. Further, a plurality of processing information pieces may include an information piece relating to an output signal of a detector provided in a motor.
(5) While the management device 4 includes the manager 149 in the above-mentioned embodiment, the present invention is not limited to this. For example, the management information is transmitted from the management device 4 to the substrate processing apparatus 1, and the management information may be output in the form of being displayed on the substrate processing apparatus 1, for example.
(6) In the substrate processing apparatus management system 100 according to the above-mentioned embodiment, the series of processes executed in the information analysis device 3 may be executed in the management device 4. Further, the series of processes executed by the information analysis device 3 may be executed by the substrate processing apparatus 1. In this case, the information analysis device 3 is not required.
(7) While being provided separately in the above-mentioned embodiment, the substrate processing apparatus 1 and the management device 4 may be provided integrally. While being provided separately in the above-mentioned embodiment, the information analysis device 3 and the management device 4 may be provided integrally.
(8) While a representative model or an average model is generated based on invariant relationships in the management device 4 of the above-mentioned embodiment, the present invention is not limited to this. For example, in the management device 4, a representative model or an average model may be generated using another machine learning method such as deep learning.
(9) While the processing information pieces PI1 to PI4 are transmitted from the processing information transmitter 113 of the substrate processing apparatus 1 to the information collector 141 of the management device 4 in the above-mentioned embodiment, the present invention is not limited to this. The processing information pieces PI1 to PI4 may be provided through a cloud on the Internet, for example. In this case, the substrate processing apparatus 1 and the management device 4 do not need to directly communicate with each other, it is possible to reduce a communication load.
(10) While the management device 4 includes the model receiver 47 and the comparer 143 in the above-mentioned embodiment, the present invention is not limited to this. For example, the management device 4 may transmit each of the processing information pieces PI1 to PI4 collected by the information collector 141 to the information analysis device 3, and may request the information analysis device 3 to calculate deviation degrees and an abnormality score. In this case, a deviation-degree table is generated by the information analysis device 3 and transmitted to the management device 4.

### 9. Correspondences Between Constituent Elements in Claims and Parts in Preferred Embodiments

In the following paragraphs, non-limiting examples of correspondences between various elements recited in the claims below and those described above with respect to various preferred embodiments of the present disclosure are explained. In the above-mentioned embodiment, the paths CEX1 to CEX4 are examples of a gas-exhaust path, the substrate processing units WU11 to WU16 are an example of a plurality of substrate processing units, the information analysis device 3 is an example of an information analysis device, the model generator 131 is an example of the model generator, the management device 4 is an example of a management device, the processing information pieces PI1 are an example of a plurality of processing information pieces, the information collector 141 is an example of a processing information acquirer, and the detector 145 is an example of a detector. The comparer 143 is an example of a deviation-degree acquirer, the gas supplier FFU is an example of a gas supplier, the first pressure sensor PG1 is an example of a first manometer, the first controller 10a is an example of a first controller, the gas exhauster ED is an example of a gas exhauster, the second pressure sensor PG2 is an example of a second manometer, and the second controller 10b is an example of a second controller. The first division path 11, the second division path 21 and the third division path 31 are an example of a plurality of division paths, and the switching device 51 is an example of a switcher.

## Claims

1. A substrate processing apparatus management system including a management device that manages a substrate processing apparatus, and an information analysis device, wherein
the substrate processing apparatus includes
a gas-exhaust path to which a predetermined exhaust force is applied, and
a plurality of substrate processing units configured to share the gas-exhaust path,
the information analysis device includes a model generator that generates group correlations as correlations in regard to a plurality of processing information pieces which correspond to each of the plurality of substrate processing units and represent work or a state relating to supply and exhaust of gas, and
the management device includes
a processing information acquirer that acquires a plurality of processing information pieces corresponding to each of the plurality of substrate processing units, and
a detector that detects a state prior to a state in which the plurality of substrate processing apparatuses become abnormal, based on comparison information obtained when correlations in regard to a plurality of processing information pieces relating to exhaust of gas among a plurality of processing information pieces acquired by the processing information acquirer are compared with the group correlations.

2. A management device that manages a substrate processing apparatus, wherein
the substrate processing apparatus includes
a gas-exhaust path to which a predetermined exhaust force is applied, and
a plurality of substrate processing units configured to share the gas-exhaust path,
group correlations are predetermined as correlations in regard to a plurality of processing information pieces which correspond to each of the plurality of substrate processing units and represent work or a state relating to supply and exhaust of gas, and
the management device includes
a processing information acquirer that acquires a plurality of processing information pieces corresponding to each of the plurality of substrate processing units, and
a detector that detects a state prior to a state in which the plurality of substrate processing apparatuses become abnormal, based on comparison information obtained when correlations in regard to a plurality of processing information pieces relating to exhaust of gas among a plurality of processing information pieces acquired by the processing information acquirer are compared with the group correlations.

3. The management device according to claim 2, wherein
types of a plurality of processing information pieces respectively acquired from the plurality of substrate processing units are same.

4. The management device according to claim 2 or 3, further comprising a deviation-degree acquirer that, for each of the plurality of substrate processing units, acquires deviation-degree information pieces representing respective degrees of deviations between respective predicted values and respective processing information pieces that corresponds to the substrate processing unit and is acquired by the processing information acquirer, with the predicted values being predicted using the group correlations based on processing information pieces that correspond to the substrate processing unit and is acquired by the processing information acquirer.

5. The management device according to any one of claims 2 to 4, wherein
each of the plurality of substrate processing units includes
a gas supplier that supplies gas into the substrate processing unit,
a first manometer that measures a pressure of gas supplied into the substrate processing unit,
a first controller that controls the gas supplier such that a pressure measured by the first manometer is a first target value,
a gas exhauster that adjusts a size of an opening that connects an inner space of the substrate processing unit to the gas-exhaust path,
a second manometer that measures a pressure of gas exhausted from the substrate processing unit, and
the second controller that controls the gas exhauster such that a pressure measured by the second manometer is a second target value,
the processing information pieces include a first pressure value measured by the first manometer, a work amount of the gas supplier, an operation amount output by the first controller to the gas supplier, a second pressure value measured by the second manometer and an opening indicating a size of the opening output by the second controller to the gas exhauster, and
a processing information piece relating to the exhaust of gas is the opening.

6. The management device according to claim 5, wherein
each of the plurality of substrate processing units processes a substrate according to any one of a plurality of types of recipes, and
the processing information pieces further include information pieces specifying the processing recipe according to which a substrate is processed in the substrate processing unit.

7. The management device according to claim 5 or 6, wherein
the gas-exhaust path has a plurality of different division paths,
the gas exhauster includes a switcher that switches a path to one of the plurality of division paths, and
the processing information pieces further include information pieces specifying the division path to which the path is switched by the switcher.

8. The management device according to any one of claims 2 to 7, wherein
the substrate processing apparatus has a plurality of the gas-exhaust paths,
the plurality of substrate processing units are classified into one of a plurality of groups respectively corresponding to the plurality of the gas-exhaust paths,
in each of the plurality of groups, a plurality of substrate processing units classified into the group are configured to share a gas-exhaust path corresponding to the group among the plurality of gas-exhaust paths,
for each of the plurality of groups, the group correlations are predetermined as correlations in regard to a plurality of processing information pieces which correspond to each of a plurality of substrate processing units classified into the group and represent work or a state relating to supply and exhaust of gas, and
the detector, for each of a plurality of groups, detects a state prior to a state in which a plurality of substrate processing units classified into the group become abnormal based on comparison information obtained when correlations, in regard to a plurality of processing information pieces which correspond to each of a plurality of substrate processing units classified into the group and relate to exhaust of gas among a plurality of processing information pieces acquired by the processing information acquirer, are compared with the group correlations corresponding to the group.

9. A substrate processing apparatus comprising the management device according to any one of claims 2 to 8.

10. A substrate processing apparatus management method of managing a substrate processing apparatus, wherein
the substrate processing apparatus includes
a gas-exhaust path to which a predetermined exhaust force is applied, and
a plurality of substrate processing units configured to share the gas-exhaust path, group correlations are predetermined as correlations in regard to a plurality of processing information pieces which correspond to each of the plurality of substrate processing units and represent work or a state relating to supply and exhaust of gas, and
the substrate processing apparatus management method causes a management device to execute
a process of acquiring a plurality of processing information pieces corresponding to each of the plurality of substrate processing units, and
a process of detecting a state prior to a state in which the plurality of substrate processing apparatus become abnormal based on comparison information obtained when correlations in regard to a plurality of processing information pieces corresponding to each of the plurality of substrate processing units and relating to exhaust of gas among a plurality of processing information pieces acquired by the processing information acquirer are compared with the group correlations.

11. A substrate processing apparatus management program for managing a substrate processing apparatus, wherein
the substrate processing apparatus includes
a gas-exhaust path to which a predetermined exhaust force is applied, and
a plurality of substrate processing units configured to share the gas-exhaust path,
group correlations are predetermined as correlations in regard to a plurality of processing information pieces which correspond to each of the plurality of substrate processing units and represent work or a state relating to supply and exhaust of gas, and
the substrate processing apparatus management program causes a management device to execute
a process of acquiring a plurality of processing information pieces corresponding to each of the plurality of substrate processing units, and
a process of detecting a state prior to a state in which the plurality of substrate processing apparatus become abnormal based on comparison information obtained when correlations in regard to a plurality of processing information pieces corresponding to each of the plurality of substrate processing units and relating to exhaust of gas among a plurality of processing information pieces acquired by the processing information acquirer are compared with the group correlations.
